# EUROPEAN PATENT SPECIFICATION

(11) **EP 3 396 726 B1**
(45) Date of publication and mention of the grant of the patent: **30.06.2021**
(21) Application number: 18169801.0
(22) Date of filing: 27.04.2018
(51) Int. Cl.: H01L 41/09, H02N 2/00

(54) **PIEZOELECTRIC DRIVE DEVICE AND DRIVE METHOD OF PIEZOELECTRIC DRIVE DEVICE**
PIEZOELEKTRISCHE ANTRIEBSVORRICHTUNG UND ANTRIEBSVERFAHREN FÜR PIEZOELEKTRISCHE ANTRIEBSVORRICHTUNG
DISPOSITIF D'ENTRAÎNEMENT PIÉZOÉLECTRIQUE ET PROCÉDÉ DE COMMANDE D'UN DISPOSITIF D'ENTRAÎNEMENT PIÉZOÉLECTRIQUE

(30) Priority: 28.04.2017 JP 2017089384
(43) Date of publication of application: 31.10.2018
(73) Proprietor: Seiko Epson Corporation, Tokyo 160-8801 (JP)
(72) Inventor: TAKAHASHI, Tomoaki, Nagano 392-8502 (JP)
(74) Representative: Hoffmann Eitle

(56) References cited:
- DE-A1-102013 203 836
- US-A1- 2016 049 886
- US-A1- 2016 241 165

## Description

### BACKGROUND

### 1. Technical Field

The present invention relates to a piezoelectric drive device, a drive method of the piezoelectric drive device, a robot, an electronic component transport apparatus, a printer, and a projector.

### 2. Related Art

The piezoelectric drive device described in JP-A-2016-152705 includes a piezoelectric drive portion for rotating a rotor (driven portion).

Here, as important parameters of the piezoelectric drive device, there are a drive force (force rotating the rotor) and a holding force (force holding the rotor) . In a case where the holding force is increased, the number of the piezoelectric drive portions may be increased. However, when the number of the piezoelectric drive portions is simply increased, the drive force becomes excessively large or a size of the device is increased.
DE 10 2013 203 836 A1 discloses a piezoelectric ultrasonic vibrating element comprising a cuboid piezoelectric body, wherein a first surface of the piezoelectric body is divided along its surface width by a first electrode assembly and/or a second surface is divided along a surface longitudinal direction thereof by a second electrode assembly.
US 2016/0241165 A1 discloses a piezoelectric drive device that includes a vibrating plate and multiple piezoelectric drive units that are disposed in the vibrating plate, and that respectively have a contact portion which can come into contact with a driven body.
US 2016/0049886 A1 discloses a piezoelectric driving device includes a vibrating plate, a first piezoelectric vibrating body which is disposed on the first surface of the vibrating plate; a second piezoelectric vibrating body which is disposed on the second surface of the vibrating plate; and a protrusion which is provided on the vibrating plate and comes into contact with a body to be driven, wherein the first piezoelectric vibrating body and the second piezoelectric vibrating body have asymmetry that the first piezoelectric vibrating body and the second piezoelectric vibrating body are asymmetrical to each other with respect to the vibrating plate.

### SUMMARY

An advantage of some aspects of the invention is to provide a piezoelectric drive device which can increase a holding force without excessively increasing a drive force, a drive method of the piezoelectric drive device, and a robot, an electronic component transport apparatus, a printer, and a projector.

The advantage described above can be achieved by the following configurations.

A piezoelectric drive device according to an aspect of the invention includes a piezoelectric vibration module including a vibration portion and a transmission portion which abuts a driven portion, which is a rotor, and is adapted to transmit vibration of the vibration portion to the driven portion, and a control unit, wherein the vibration portion includes a first vibration portion and a second vibration portion disposed to be stacked in a second direction intersecting a first direction which is a direction in which the vibration portion is aligned with the driven portion, wherein the piezoelectric vibration module includes a first piezoelectric vibration module and a second piezoelectric vibration module stacked in the second direction, the first piezoelectric vibration module being disposed in a pair so as to sandwich the second piezoelectric vibration module therebetween, wherein the first piezoelectric vibration module includes the first vibration portion and the second vibration module includes the second vibration portion, and the control unit is configured to cause the first vibration portion to perform lateral vibration to vibrate in a third direction intersecting the first direction and the second direction, and is configured to cause the second vibration portion to perform longitudinal vibration to vibrate in the first direction.

With this configuration, it is possible to obtain a piezoelectric drive device capable of increasing the holding force of the driven portion without excessively increasing the drive force of the driven portion.

Further, in the piezoelectric drive device according to the aspect of the invention, the control unit is adapted to cause the first vibration portion to perform composite vibration of vibration in the third direction and vibration in the first direction, and the transmission portion is configured to perform rotation vibration by combination of lateral vibration of the first vibration portion and longitudinal vibration of the second vibration portion, such that, in use, the driven portion is substantially moved only by the vibration of the first vibration portion, and the driven portion is held by both the first vibration portion and the second vibration portion.

With this configuration, it is possible to further increase amplitude of longitudinal vibration of the vibration portion. For that reason, the vibration portion can be pressed against the driven portion with a stronger pressing force and a holding force of the driven portion can be further increased.

In the piezoelectric drive device according to the aspect of the invention, it is preferable that, in a case where the control unit is adapted to individually drive the first vibration portion and the second vibration portion in a state where the transmission portion is not in contact with the driven portion, amplitude of the transmission portion in the first direction due to the vibration of the second vibration portion in the first direction is larger than the amplitude of the transmission portion in the first direction due to the vibration of the first vibration portion in the first direction.

With this configuration, it is possible to make the amplitude of the longitudinal vibration of the transmission portion larger. For that reason, the vibration portion can be pressed against the driven portion with a stronger pressing force and a holding force of the driven portion can be further increased.

In the piezoelectric drive device according to the aspect of the invention, it is preferable that the first vibration portion and the second vibration portion have different configurations.

With this configuration, it is possible to configure the first vibration portion and the second vibration portion to have suitable configurations, respectively, so that a piezoelectric drive device capable of performing more efficient driving is obtained.

In the piezoelectric drive device according to the aspect of the invention, it is preferable that an area of a vibration region in which the vibration of the second vibration portion in the first direction is adapted to be caused is larger than an area of the vibration region in which the vibration of the first vibration portion in the first direction is adapted to be caused.

With this configuration, it is possible to more reliably make the amplitude of the longitudinal vibration of the second vibration portion larger than the amplitude of the longitudinal vibration of the first vibration portion. With this, it is possible to increase the amplitude of the longitudinal vibration of the transmission portion. For that reason, the vibration portion can be pressed against the driven portion with a stronger pressing force and a holding force of the driven portion can be further increased.

In the piezoelectric drive device according to the aspect of the invention, it is preferable that the first vibration portion and the second vibration portion have the same configuration.

With this configuration, it is possible to make parts common in the first vibration portion and the second vibration portion and to reduce the cost of the piezoelectric vibration module.

In the piezoelectric drive device according to the aspect of the invention, it is preferable that each of the first vibration portion and the second vibration portion has at least one pair of vibration regions disposed side by side in the third direction, and the control unit is adapted to cause the first vibration portion to vibrate in the third direction by expanding and contracting the pair of vibration regions at different phases, and is adapted to cause the second vibration portion to vibrate in the first direction by expanding and contracting the pair of vibration regions at the same phase.

With this configuration, it is possible to laterally vibrate the first vibration portion and longitudinally vibrate the second vibration portion with a simple configuration.

In the piezoelectric drive device according to the aspect of the invention, it is preferable that the first vibration portion and the second vibration portion are disposed symmetrically in the second direction.

With this configuration, it is possible to suppress deflection in the second direction (thickness direction) during vibration of the vibration portion and to more efficiently vibrate the transmission portion.

A drive method according to another aspect of the invention is a drive method of a piezoelectric drive device, which includes a piezoelectric vibration module including a vibration portion and a transmission portion which abuts a driven portion, which is a rotor, and transmits vibration of the vibration portion to the driven portion, and the method includes configuring the vibration portion to include a first vibration portion and a second vibration portion disposed side by side in a second direction intersecting a first direction which is a direction in which the vibration portion is aligned with the driven portion, configuring the piezoelectric vibration module to include a first piezoelectric vibration module and a second piezoelectric vibration module stacked in the second direction, the first piezoelectric vibration module being disposed in a pair so as to sandwich the second piezoelectric vibration module therebetween, wherein the first piezoelectric vibration module includes the first vibration portion and the second vibration module includes the second vibration portion, and causing the transmission portion to rotationally vibrate by causing the second vibration portion to perform longitudinal vibration to vibrate in the first direction while causing the first vibration portion to perform lateral direction to vibrate in a third direction intersecting the first direction and the second direction, wherein the control unit causes the first vibration portion to perform composite vibration of vibration in the third direction and vibration in the first direction, and the transmission portion performs rotation vibration by combination of lateral vibration of the first vibration portion and longitudinal vibration of the second vibration portion, such that the driven portion is substantially moved only by the vibration of the first vibration portion (41), and the driven portion is held by both the first vibration portion and the second vibration portion.

With this configuration, it is possible to increase a holding force of the driven portion without excessively increasing the drive force of the driven portion.

A robot according to another aspect of the invention includes the piezoelectric drive device according to the aspect of the invention.

With this configuration, it is possible to achieve the effects of the piezoelectric drive device according to the aspect of the invention and obtain a highly reliable robot.

An electronic component transport apparatus according to another aspect of the invention includes the piezoelectric drive device according to the aspect of the invention.

With this configuration, it is possible to achieve the effects of the piezoelectric drive device according to the aspect of the invention and obtain a highly reliable electronic component transport apparatus.

A printer according to another aspect of the invention includes the piezoelectric drive device according to the aspect of the invention.

With this configuration, it is possible to achieve the effects of the piezoelectric drive device according to the aspect of the invention and obtain a highly reliable printer.

A projector according to an aspect of the invention includes the piezoelectric drive device according to the aspect of the invention.

With this configuration, it is possible to achieve the effects of the piezoelectric drive device according to the aspect of the invention and obtain a highly reliable projector.

### BRIEF DESCRIPTION OF THE DRAWINGS

The invention will be described with reference to the accompanying drawings, wherein like numbers reference like elements.
Fig. 1 is a perspective view illustrating a piezoelectric drive device according to a first embodiment of the invention.
Fig. 2 is a side view illustrating a piezoelectric vibration module included in the piezoelectric drive device illustrated in Fig. 1.
Fig. 3 is a plan view of a first piezoelectric vibration module included in the piezoelectric vibration module illustrated in Fig. 2.
Fig. 4 is a cross-sectional view taken along line A-A in Fig. 3.
Fig. 5 is a cross-sectional view taken along line B-B in Fig. 3.
Fig. 6 is a diagram illustrating a vibration state of the first piezoelectric vibration module illustrated in Fig. 3.
Fig. 7 is a diagram illustrating a waveform of a voltage applied to the first piezoelectric vibration module.
Fig. 8 is a plan view of a second piezoelectric vibration module included in the piezoelectric vibration module illustrated in Fig. 2.
Fig. 9 is a cross-sectional view taken along line C-C in Fig. 8.
Fig. 10 is a view illustrating a vibration state of the second piezoelectric vibration module illustrated in Fig. 8 .
Fig. 11 is a diagram illustrating a waveform of a voltage applied to the second piezoelectric vibration module.
Fig. 12 is a side view for explaining an electrical connection method of the piezoelectric vibration module illustrated in Fig. 2.
Fig. 13 is another side view for explaining an electrical connection method of the piezoelectric vibration module illustrated in Fig. 2.
Fig. 14 is a diagram for explaining a drive method of the piezoelectric drive device illustrated in Fig. 1.
Fig. 15 is another diagram for explaining the drive method of the piezoelectric drive device illustrated in Fig. 1.
Fig. 16 is a side view illustrating a piezoelectric vibration module having a configuration of the related art.
Fig. 17 is a table illustrating an example of a drive force and a holding force that can be realized by a configuration of the related art.
Fig. 18 is a side view illustrating a piezoelectric vibration module according to the invention.
Fig. 19 is a table illustrating an example of drive force and holding force that can be achieved with the configuration according to the invention.
Fig. 20 is a side view illustrating a modification example of the piezoelectric vibration module illustrated in Fig. 2.
Fig. 21 is another side view illustrating the modification example of the piezoelectric vibration module illustrated in Fig. 2.
Fig. 22 is another side view illustrating the modification example of the piezoelectric vibration module illustrated in Fig. 2.
Fig. 23 is a plan view of a first piezoelectric vibration module included in a piezoelectric drive device according to a second embodiment of the invention.
Fig. 24 is a diagram illustrating a vibration state of the first piezoelectric vibration module illustrated in Fig. 23.
Fig. 25 is a diagram illustrating a waveform of a voltage applied to the first piezoelectric vibration module.
Fig. 26 is a plan view of a second piezoelectric vibration module included in a piezoelectric drive device according to a third embodiment of the invention.
Fig. 27 is a diagram illustrating a vibration state of the second piezoelectric vibration module illustrated in Fig. 26.
Fig. 28 is a diagram illustrating a waveform of a voltage applied to the second piezoelectric vibration module.
Fig. 29 is a perspective view illustrating a piezoelectric drive device according to a fourth embodiment of the invention.
Fig. 30 is a perspective view illustrating a robot according to a fifth embodiment of the invention.
Fig. 31 is a perspective view illustrating an electronic component transport apparatus according to a sixth embodiment of the invention.
Fig. 32 is a perspective view illustrating an electronic component holding unit included in the electronic component transport apparatus illustrated in Fig. 31.
Fig. 33 is a schematic diagram illustrating an overall configuration of a printer according to a seventh embodiment of the invention.
Fig. 34 is a schematic diagram illustrating an overall configuration of a projector according to an eighth embodiment of the invention.

### DESCRIPTION OF EXEMPLARY EMBODIMENTS

Hereinafter, a piezoelectric drive device, a drive method of the piezoelectric drive device, a robot, an electronic component transport apparatus, a printer, and a projector according to the invention will be described in detail based on embodiments illustrated in the accompanying drawings.

### First Embodiment

First, a piezoelectric drive device according to a first embodiment of the invention will be described.

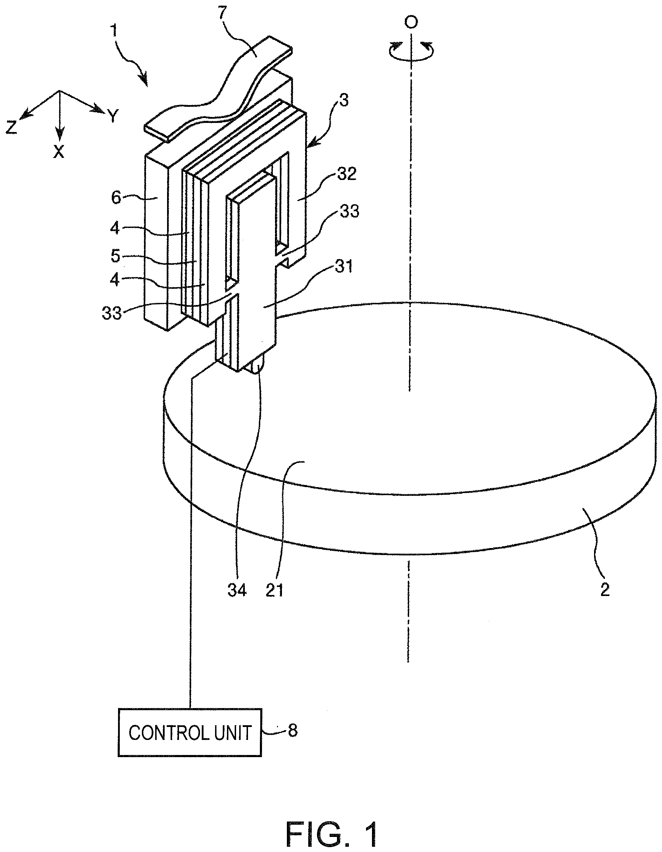

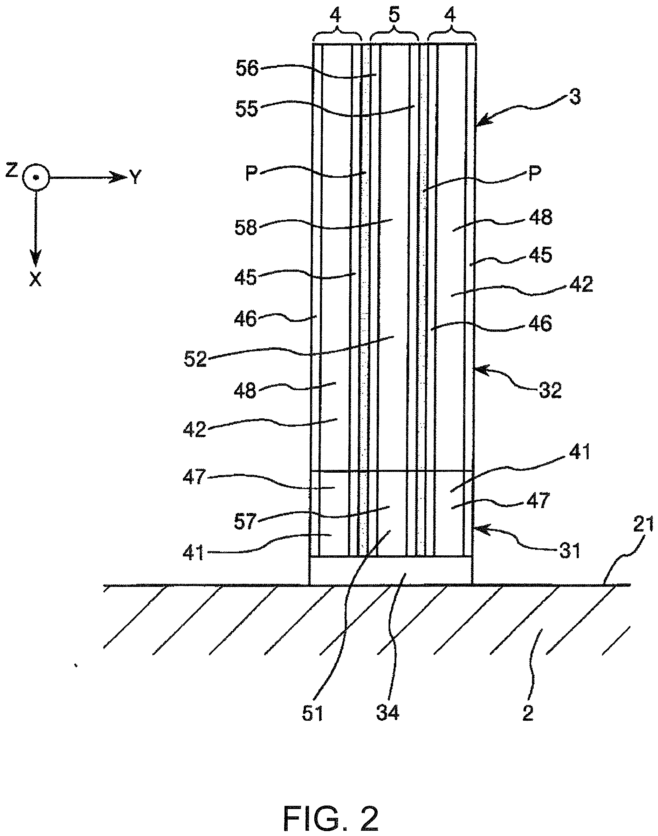

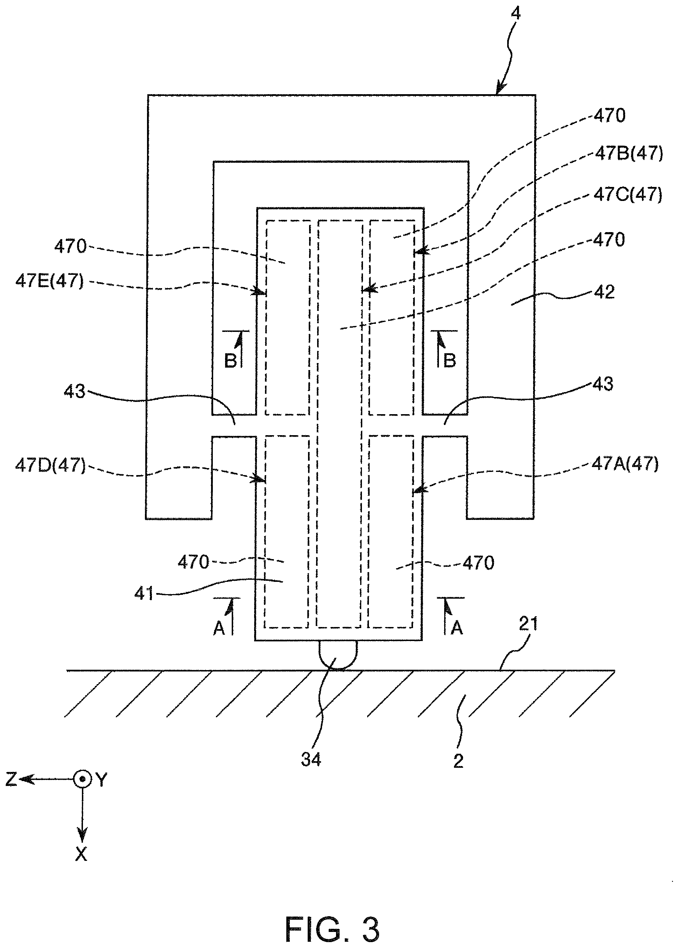

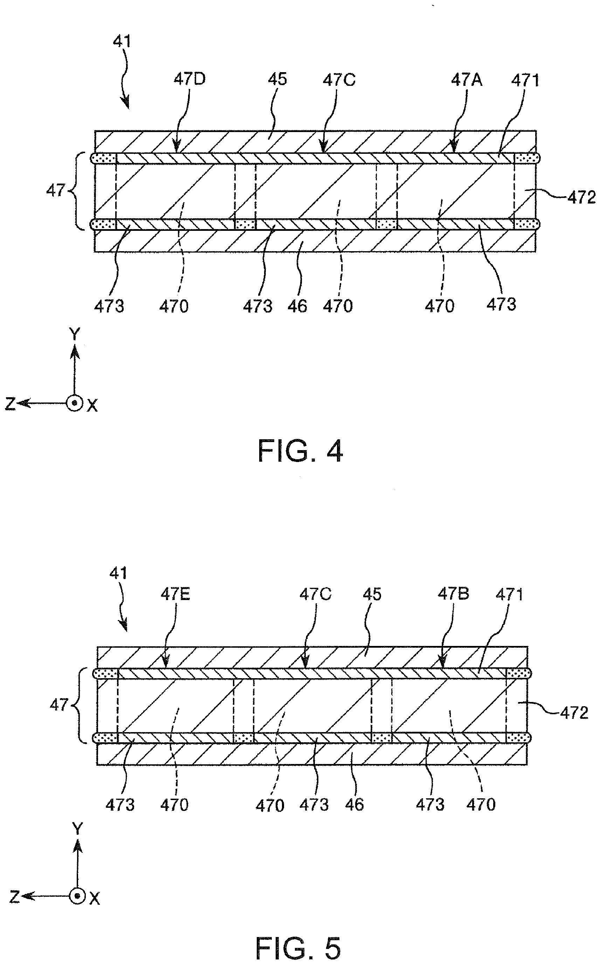

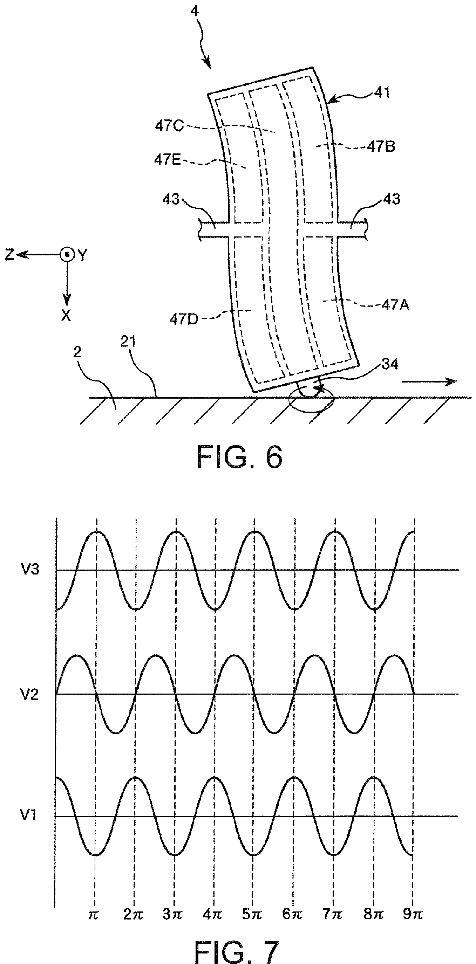

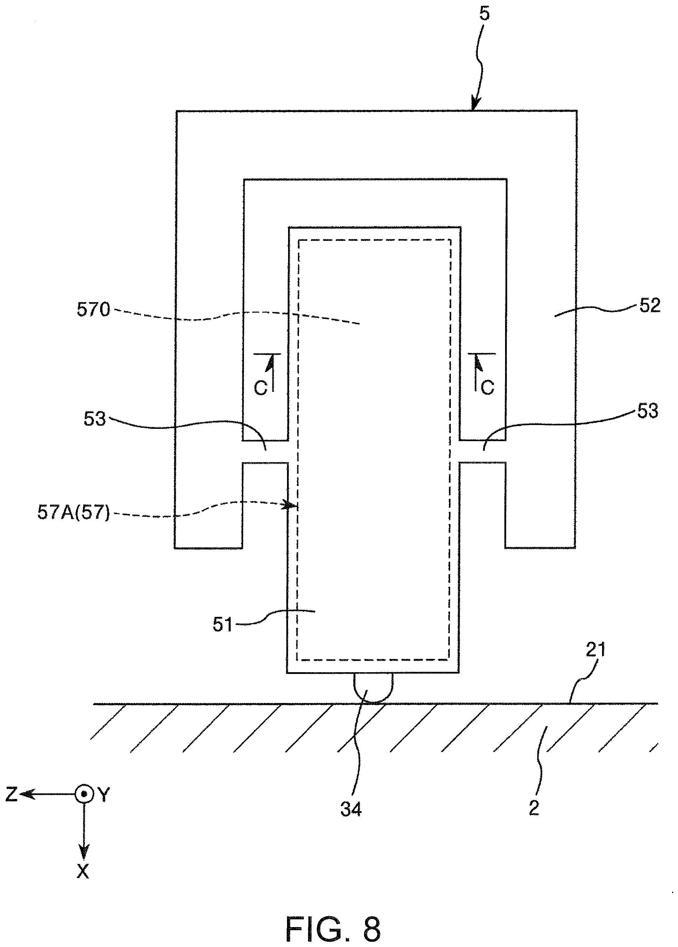

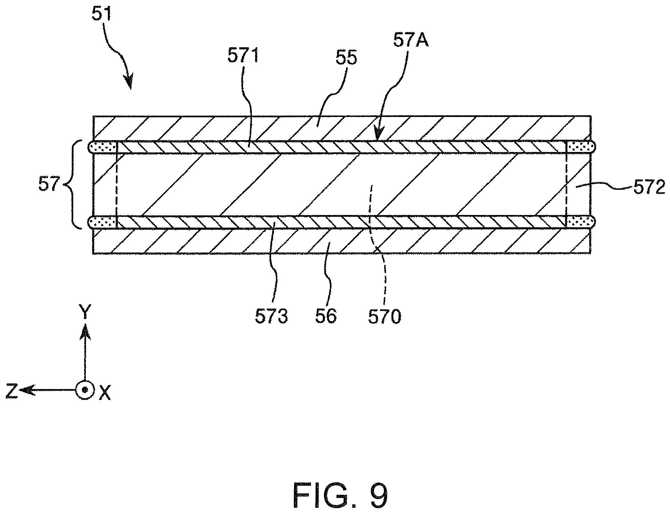

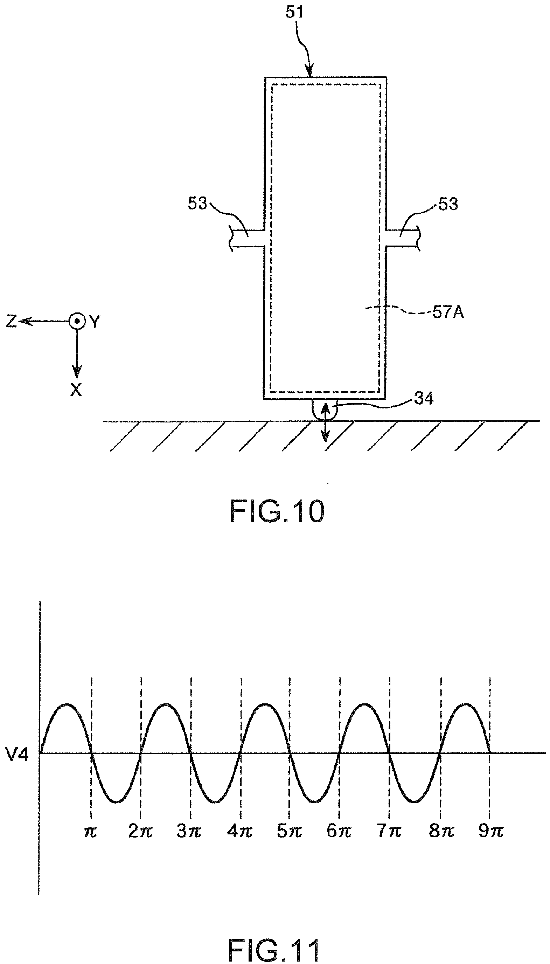

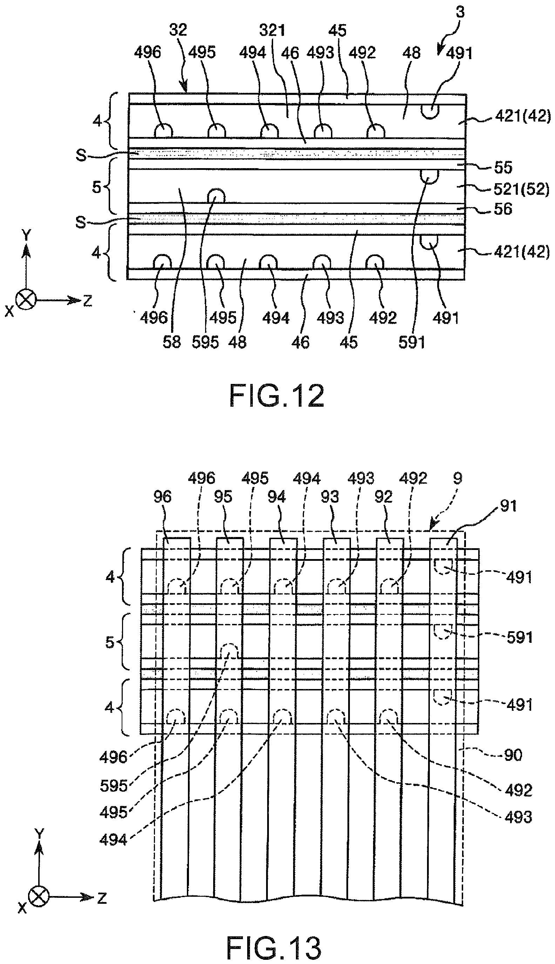

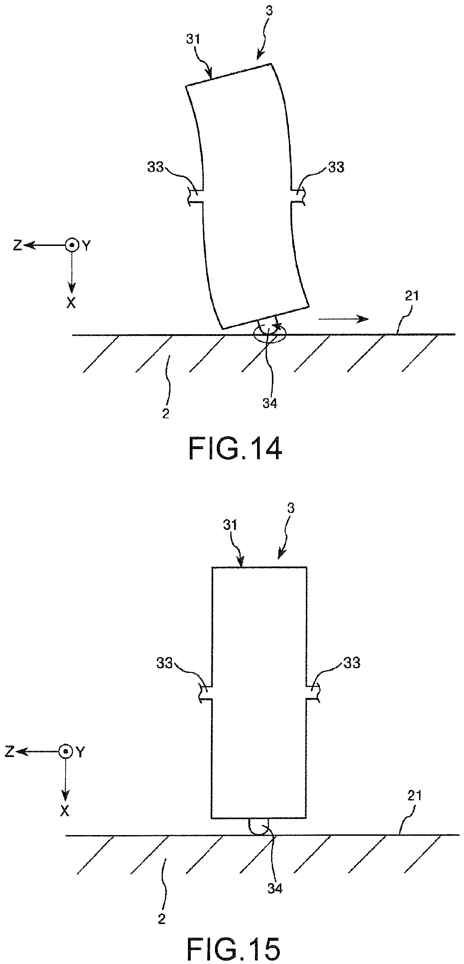

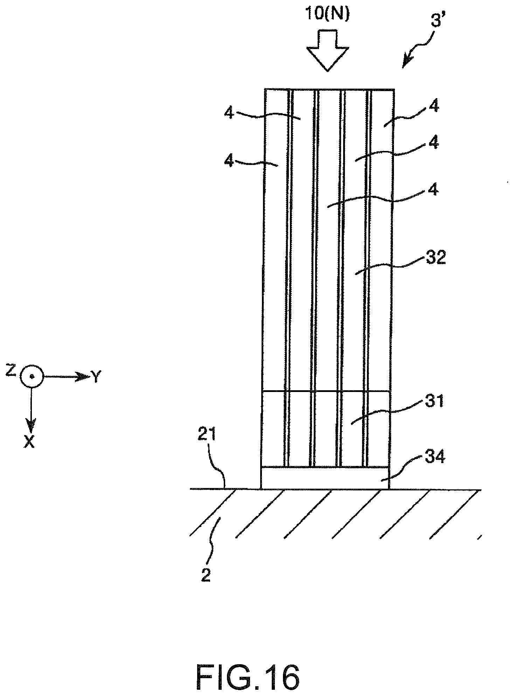

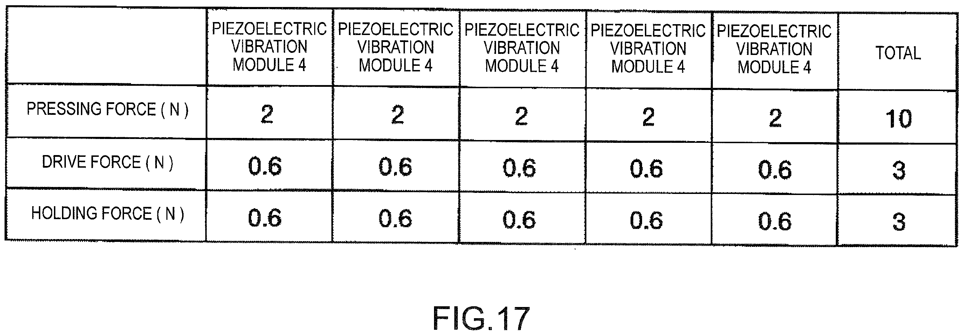

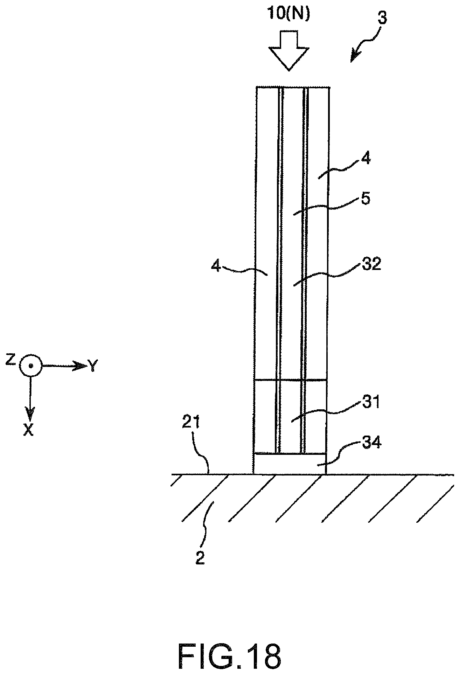

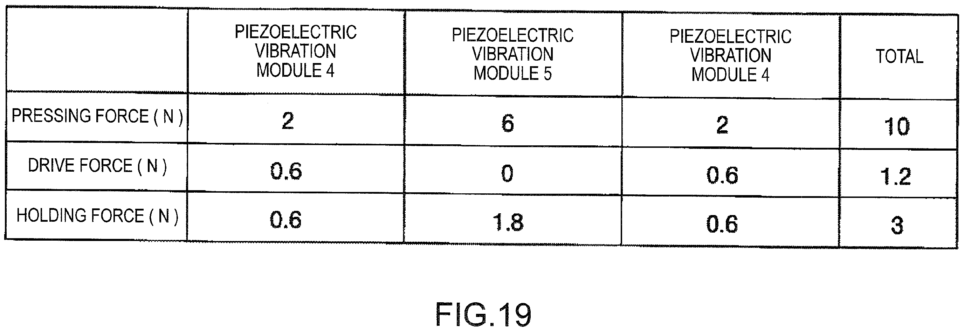

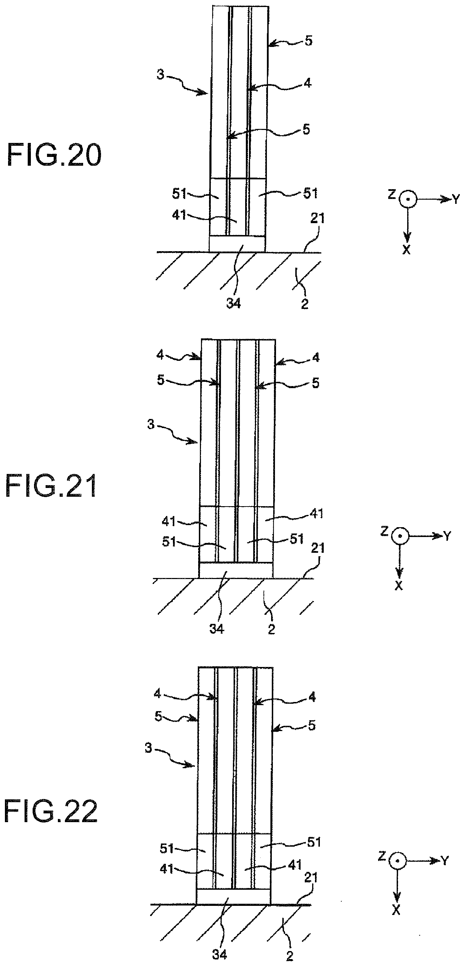

Fig. 1 is a perspective view illustrating a piezoelectric drive device according to a first embodiment of the invention. Fig. 2 is a side view illustrating a piezoelectric vibration module included in the piezoelectric drive device illustrated in Fig. 1. Fig. 3 is a plan view of a first piezoelectric vibration module included in the piezoelectric vibration module illustrated in Fig. 2. Fig. 4 is a cross-sectional view taken along line A-A in Fig. 3. Fig. 5 is a cross-sectional view taken along line B-B in Fig. 3. Fig. 6 is a diagram illustrating a vibration state of a first piezoelectric vibration module illustrated in Fig. 3. Fig. 7 is a diagram illustrating a waveform of a voltage applied to the first piezoelectric vibration module. Fig. 8 is a plan view of a second piezoelectric vibration module included in the piezoelectric vibration module illustrated in Fig. 2. Fig. 9 is a cross-sectional view taken along line C-C in Fig. 8. Fig. 10 is a view illustrating a vibration state of the second piezoelectric vibration module illustrated in Fig. 8. Fig. 11 is a diagram illustrating a waveform of a voltage applied to the second piezoelectric vibration module. Fig. 12 is a side view for explaining an electrical connection method of the piezoelectric vibration module illustrated in Fig. 2. Fig. 13 is another side view for explaining an electrical connection method of the piezoelectric vibration module illustrated in Fig. 2. Figs. 14 and 15 are diagrams for explaining a drive method of the piezoelectric drive device illustrated in Fig. 1, respectively. Fig. 16 is a side view illustrating a piezoelectric vibration module having a configuration of the related art. Fig. 17 is a table illustrating an example of a drive force and a holding force that can be realized by a configuration of the related art. Fig. 18 is a side view illustrating a piezoelectric vibration module according to the invention. Fig. 19 is a table illustrating an example of drive force and holding force that can be achieved with the configuration according to the invention. Figs. 20, 21, and 22 are side views illustrating a modification example of the piezoelectric vibration module illustrated in Fig. 2, respectively. In the following description, for convenience of description, the upper side and the lower side in Figs. 4, 5 and 9 are also referred to as "upper" and "lower", respectively.

The piezoelectric drive device 1 illustrated in Fig. 1 is used as a rotary motor (ultrasonic motor), and includes a rotor 2 (driven portion) rotatable around a rotation axis 0, a piezoelectric vibration module 3 abuts on an upper surface 21 of the rotor 2, a stage 6 that supports the piezoelectric vibration module 3, an urging portion 7 that urges the piezoelectric vibration module 3 toward the rotor 2 via the stage 6, a control unit 8 that controls driving of the piezoelectric vibration module 3. The number of the piezoelectric vibration modules 3 is not particularly limited, and may be two or more.

As illustrated in Fig. 1, the rotor 2 has a disc shape and is rotatably bearing supported around the rotation axis O. Then, the piezoelectric vibration module 3 is disposed by being abutted on the upper surface 21 of the rotor 2. However, the configuration of the rotor 2 is not particularly limited, and for example, a shape in plan view may not be circular. A disposition of the piezoelectric vibration module 3 is not particularly limited as long as the rotor 2 can be rotated, and the piezoelectric vibration module 3 may be disposed so as to be abutted on a side surface of the rotor 2, for example.

As illustrated in Fig. 1, the piezoelectric vibration module 3 includes a vibration portion 31 capable of vibrating, a support portion 32 supporting the vibration portion 31, a pair of connection portions 33 connecting the vibration portion 31 and the support portion 32, and a transmission portion 34 provided in the vibration portion 31. The vibration portion 31 is formed in a substantially rectangular plate shape and a transmission portion 34 is provided at a tip portion thereof. Further, the support portion 32 has a U shape to surround a base end side of the vibration portion 31.

The piezoelectric vibration module 3 having such a configuration abuts against the upper surface 21 of the rotor 2 at the tip end of the transmission portion 34 and is fixed to the stage 6 at the support portion 32. The stage 6 is urged toward the rotor 2 side (lower side in Fig. 1) by the urging portion 7 such as a spring member (leaf spring, spring spring) or the like, so that the transmission portion 34 is in contact with the upper surface 21 of the rotor 2 with a sufficient frictional force. For that reason, slipping is suppressed and vibration of the vibration portion 31 can be efficiently transmitted to the rotor 2 via the transmission portion 34.

However, the configuration of the piezoelectric vibration module 3 is not particularly limited, and for example, the support portion 32 and the connection portion 33 may be omitted. In the following description, for convenience of description, the alignment direction of the vibration portion 31 and the rotor 2 (longitudinal direction of the vibration portion 31) is also referred to as a "first direction X", the thickness direction of the piezoelectric vibration modules 3 orthogonal to (intersecting) the first direction X (normal direction of a vibration plane) is also referred to as a "second direction Y", and the width direction of the vibration portion 31 orthogonal to (intersecting) the first direction and the second direction is also referred to as a "third direction Z". A plane defined by the first direction X and the third direction Z is also referred to as an "XZ plane".

As illustrated in Fig. 2, the piezoelectric vibration module 3 includes a first piezoelectric vibration module 4 and a second piezoelectric vibration module 5 stacked in the second direction Y. The first piezoelectric vibration module 4 is disposed in a pair so as to sandwich the second piezoelectric vibration module 5 therebetween. That is, the first piezoelectric vibration module 4 and the second piezoelectric vibration module 5 are symmetrically disposed in the second direction Y. The first piezoelectric vibration module 4 and the second piezoelectric vibration module 5 are joined by a joining member S such as an adhesive. The configuration of the piezoelectric vibration module 3 is not particularly limited as long as the piezoelectric vibration module 3 includes at least one first piezoelectric vibration module 4 and at least one second piezoelectric vibration module 5 .

In the first embodiment, the integral transmission portion 34 is disposed across the first piezoelectric vibration module 4, the second piezoelectric vibration module 5, and the first piezoelectric vibration module 4, but the invention is not limited thereto. For example, the transmission portion 34 is separate for each of the first piezoelectric vibration module 4, the second piezoelectric vibration module 5, and the first piezoelectric vibration module 4 and may be configured such that the first and second piezoelectric vibration modules 4 and 5 are fixed with an adhesive. In a case where the transmission portions 34 are formed as the separate bodies as described above, some of the transmission portions 34 may be omitted.

The first piezoelectric vibration module 4 has both functions of a function as the drive portion that rotates (moves) the rotor 2 around the rotation axis O and a function as the holding unit that holds the rotor 2 in that state. On the other hand, the second piezoelectric vibration module 5 substantially does not have a function as the drive portion for rotating the rotor 2 around the rotation axis O and only has the function as the holding unit for holding the rotor 2 in that state. That is, the piezoelectric vibration module 3 is configured in such a way that the rotor 2 is rotated by the first piezoelectric vibration module 4 and the rotor 2 is held by the first piezoelectric vibration module 4 and the second piezoelectric vibration module 5.

As such, it is possible to suppress excessive increase (more than necessary) of a drive force of the rotor 2 by rotating the rotor 2 substantially only by the drive force of the first piezoelectric vibration module 4. It is possible to further increase the holding force of the rotor 2 by holding the rotor 2 by both the first piezoelectric vibration module 4 and the second piezoelectric vibration module 5. For that reason, it is possible to obtain the piezoelectric drive device 1 capable of increasing the holding force without excessively increasing the drive force.

As illustrated in Fig. 3, the first piezoelectric vibration module 4 includes a vibration portion 41 (first vibration portion) capable of vibrating in the XZ plane, a support portion 42 supporting the vibration portion 41, and a pair of connection portions 43 connecting the vibration portion 41 and the support portion 42. The vibration portion 41 has a substantially rectangular plate shape extending in the first direction X, and a transmission portion 34 is provided at a tip end of the vibration portion 41. The support portion 42 has a U shape to surround a base end side of the vibration portion 41. However, the shape and disposition of these components are not particularly limited.

As illustrated in Fig. 2, the first piezoelectric vibration module 4 includes a first substrate 45 and a second substrate 46 disposed to face each other in the second direction Y. The vibration portion 41 includes a piezoelectric element 47 provided between the first substrate 45 and the second substrate 46, and the support portion 42 includes a spacer 48 provided between the first substrate 45 and the second substrate 46. The spacer 48 functions as a spacer for equalizing the thickness of the support portion 42 to the thickness of the vibration portion 41. A configuration of the first piezoelectric vibration module 4 is not particularly limited, and for example, one of the first substrate 45 and the second substrate 46 may be omitted.

As illustrated in Fig. 3, the piezoelectric element 47 includes five piezoelectric elements 47A, 47B, 47C, 47D, and 47E. The piezoelectric elements 47A and 47B are positioned at one side (right side in Fig. 3) in the width direction of the vibration portion 41 and are disposed side by side in the longitudinal direction of the vibration portion 41. The piezoelectric elements 47D and 47E are positioned at the other side (left side in Fig. 3) in the width direction of the vibration portion 41 and are disposed side by side in the longitudinal direction of the vibration portion 41. The piezoelectric element 47C is positioned at the center in the width direction of the vibration portion 41 and is disposed along the longitudinal direction of the vibration portion 41. The configuration of the piezoelectric element 47 is not particularly limited as long as lateral vibration described below can be generated, and for example, the piezoelectric element 47C may be omitted therefrom.

As illustrated in Figs.4 and 5, the five piezoelectric elements 47A, 47B, 47C, 47D, and 47E respectively include a piezoelectric body 472, a first electrode 471 provided on the upper surface of the piezoelectric body 472, and second electrodes 473 provided on the lower surface of the piezoelectric body 472. A region sandwiched between the first electrode 471 and the second electrodes 473 of the piezoelectric body 472 is formed as a vibration region 470.

The first electrode 471 is a common electrode commonly provided for the piezoelectric elements 47A, 47B, 47C, 47D, and 47E. On the other hand, the second electrodes 473 are individual electrodes individually provided for each of the piezoelectric elements 47A, 47B, 47C, 47D, and 47E. Here, the widths (lengths along the third direction Z) of the second electrodes 473 of the piezoelectric elements 47A, 47B, 47C, 47D, and 47E are substantially equal to each other. Each of the lengths (lengths along the first direction X) of the second electrodes 473 of the piezoelectric elements 47A, 47B, 47D, and 47E is approximately one half of the length of the second electrode 473 of the piezoelectric element 47C. However, the size of each of the second electrodes 473 of the piezoelectric elements 47A, 47B, 47C, 47D, and 47E is not limited thereto.

The piezoelectric body 472 is provided integrally with the piezoelectric elements 47A, 47B, 47C, 47D, and 47E in common. The piezoelectric body 472 may be separately provided for each of the piezoelectric elements 47A, 47B, 47C, 47D, and 47E.

As an electric field in a direction along the thickness direction (second direction Y) of the vibration portion 41 is applied, the piezoelectric body 472 expands and contracts in the longitudinal direction (first direction X) of the vibration portion 41. As constituent material of the piezoelectric body 472, for example, piezoelectric ceramics such as lead zirconate titanate (PZT), barium titanate, lead titanate, potassium niobate, lithium niobate, lithium tantalate, sodium tungstate, zinc oxide, barium strontium titanate (BST), strontium bismuth tantalate (SBT), lead metaniobate, lead scandium niobate, and the like can be used. The piezoelectric body 472 made of piezoelectric ceramics may be formed of, for example, a bulk material, or may be formed by a sol-gel method or a sputtering method. In addition to the piezoelectric ceramics described above, polyvinylidene fluoride, quartz, or the like may be used as the constituent material of the piezoelectric body 472.

As illustrated in Fig. 6, the first piezoelectric vibration module 4 configured as described above can vibrate so as to cause the transmission portion 34 to perform rotation vibration (elliptical vibration) counterclockwise in the figure. In order to perform such vibration, for example, a voltage V1 illustrated in Fig. 7 is applied to the piezoelectric elements 47A and 47E, a voltage V2 is applied to the piezoelectric element 47C, and a voltage V3 is applied to the piezoelectric elements 47B and 47D. With this, the vibration portion 41 performs lateral vibration that bends at second order in the third direction Z while performing longitudinal vibration that expands and contracts in the first direction X. Such longitudinal vibration and lateral vibration are combined and the vibration portion 41 bends and vibrates in an S shape and accordingly, the transmission portion 34 performs rotation vibration (elliptical vibration) which is composite vibration of the longitudinal vibration and the lateral vibration. As such, it is possible to cause the transmission portion 34 to rotationally vibrate by expanding and contracting the piezoelectric elements 47A and 47E, the piezoelectric elements 47B and 47D, and the piezoelectric element 47C at different phases. However, a voltage pattern to be applied to the first piezoelectric vibration module 4 is not particularly limited as long as it is possible to cause the transmission portion 34 to be rotationally vibrated.

Next, the second piezoelectric vibration module 5 will be described. The second piezoelectric vibration module 5 has substantially the same configuration as in the first piezoelectric vibration module 4 described above, except that the configuration of the piezoelectric element 57 is different. That is, as illustrated in Fig. 8, the second piezoelectric vibration module 5 includes a vibration portion 51 (second vibration portion) capable of vibrating in the XZ plane, a support portion 52 supporting the vibration portion 51, and a pair of connection portions 53 connecting the vibration portion 51 and the support portion 52. The vibration portion 51 is formed in a substantially rectangular plate shape extending in the first direction X, and a transmission portion 34 is provided at a tip portion thereof. Further, the support portion 52 has a U shape to surround a base end side of the vibration portion 51. However, the shape and disposition of these components are not particularly limited.

As illustrated in Fig. 2, the second piezoelectric vibration module 5 includes a first substrate 55 and a second substrate 56 disposed to face each other in the second direction Y. The vibration portion 51 includes a piezoelectric element 57 provided between the first substrate 55 and the second substrate 56, and the support portion 52 includes a spacer 58 provided between the first substrate 55 and the second substrate 56. The spacer 58 functions as a spacer for equalizing the thickness of the support portion 52 to the thickness of the vibration portion 51. A configuration of the second piezoelectric vibration module 5 is not particularly limited, and for example, one of the first substrate 55 and the second substrate 56 may be omitted.

As illustrated in Fig. 9, the piezoelectric element 57 includes one piezoelectric element 57A disposed so as to spread over the substantially entire area of the vibration portion 51. The piezoelectric element 57A includes a piezoelectric body 572, a first electrode 571 provided on the upper surface of the piezoelectric body 572, and a second electrode 573 provided on the lower surface of the piezoelectric body 572. Accordingly, a region sandwiched between the first electrode 571 and the second electrode 573 of the piezoelectric body 572 corresponds to the vibration region 570.

As illustrated in Fig. 10, the second piezoelectric vibration module 5 configured as described above can vibrate the transmission portion 34 in the first direction X. In order to perform such vibration, for example, a voltage V4 illustrated in Fig. 11 is applied to the piezoelectric element 57A. With this, the vibration portion 51 performs longitudinal vibration that expands and contracts in the first direction X and accordingly, the transmission portion 34 performs longitudinal vibration in the first direction X. The longitudinal vibration of the second piezoelectric vibration module 5 is excited together with the rotation vibration of the first piezoelectric vibration module 4. Specifically, the voltage V2 applied to the piezoelectric element 47C of the first piezoelectric vibration module 4 is also applied to the piezoelectric element 57A of the second piezoelectric vibration module 5 so as to cause the piezoelectric element 57A and the piezoelectric element 47C to expand and contract at the same phase. With this, since the vibration portions 41 and 51 are longitudinally vibrated at the same phase, it is possible to cause the transmission portion 34 to be rotationally vibrated with a smooth trajectory and to amplify the amplitude of the longitudinal vibration of the transmission portion 34.

As described above, longitudinal vibration is generated in the transmission portion 34 due to expansion and contraction of the piezoelectric element 57A included in the second piezoelectric vibration module 5 and expansion and contraction of the piezoelectric element 47C included in the first piezoelectric vibration module 4. Here, since the vibration region 570 of the piezoelectric element 57A is larger than the vibration region 470 of the piezoelectric element 47C, the amplitude of the longitudinal vibration of the transmission portion 34 can be made larger by the longitudinal vibration of the second piezoelectric vibration module 5. That is, in the piezoelectric vibration module 3, for example, the amplitude of the longitudinal vibration of the transmission portion 34 becomes larger compared to a case where the piezoelectric vibration module 3 has a configuration obtained by stacking three first piezoelectric vibration modules 4 (configuration in which the second piezoelectric vibration module 5 is replaced by the first piezoelectric vibration module 4). When the amplitude of the longitudinal vibration of the transmission portion 34 increases, force of the longitudinal vibration increases and a pressing force of the piezoelectric vibration module 3 against the rotor 2 can be increased that much of the force. For that reason, it is possible to further increase the holding force of the rotor 2. In the first embodiment, the area of the vibration region 570 of the piezoelectric element 57A is approximately three times the area of the vibration region 470 of the piezoelectric element 47C. For that reason, the amplitude of the longitudinal vibration of the transmission portion 34 caused by the longitudinal vibration of the piezoelectric element 57A is approximately three times the amplitude of the longitudinal vibration of the transmission portion 34 caused by the longitudinal vibration of the piezoelectric element 47A.

The "amplitude of longitudinal vibration" means that the first piezoelectric vibration module 4 and the second piezoelectric vibration module 5 are each considered as a single body, and furthermore, the amplitude of the transmission portion 34 in a state where the first and second piezoelectric vibration modules 4 and 5 are not in contact with the rotor 2 (state not in contact with another member, hereinafter, also referred to as a "natural state"). In other words, it means that when the piezoelectric vibration module 3 is constituted by one first piezoelectric vibration module 4 and the amplitude of the longitudinal vibration of the transmission portion 34 at the time when the transmission portion 34 is rotationally vibrated in a free state without abutting the rotor 2 is set to G1 and when the piezoelectric vibration module 3 is constituted by one second piezoelectric vibration module 5 and the amplitude of the longitudinal vibration of the transmission portion 34 at the time when the transmission portion 34 is longitudinally vibrated in a free state without abutting the rotor 2 is set to G2, the relationship of G2 > G1 is satisfied.

Here, the relationship of G1 and G2 is preferably 2 ≤ G2/G1 ≤ 10, and more preferably 3 ≤ G2/G1 ≤ 5. With this, it is possible to make the amplitude G2 sufficiently large and exert higher holding force.

The piezoelectric vibration module 3 has been described as above. In such a piezoelectric vibration module 3, the vibration portion 31 is constituted with a stacked body of the vibration portions 41, 51, and 41, the support portion 32 is constituted with a stacked body of the support portions 42, 52, and 42, the connection portion 33 is constituted with a stacked body of the connection portions 43, 53, and 43.

Here, an example of the methods for electrically connecting two first piezoelectric vibration modules 4 and one second piezoelectric vibration module 5 included in the piezoelectric vibration module 3 will be described. But, these electrical connection methods are not limited to the following methods.

As illustrated in Fig. 12, the first piezoelectric vibration module 4 includes six terminals 491, 492, 493, 494, 495, and 496 protruding from a base end surface 421 on the base end surface 421 of the support portion 42. Among the terminals, the terminal 491 is provided at the first substrate 45 side of the spacer 48 and the remaining terminals 492, 493, 494, 495, and 496 are provided at the second substrate 46 side of the spacer 48. These terminals 491, 492, 493, 494, 495, and 496 are disposed at intervals in the third direction Z (width direction of the piezoelectric vibration module 3) without overlapping each other in the second direction Y (thickness direction of the piezoelectric vibration module 3).

Each of the terminals 491 is electrically connected to the first electrode 471 of the piezoelectric element 47 via a wiring (not illustrated) provided on the inner surface of the first substrate 45. The terminal 492 is electrically connected to the second electrode 473 of the piezoelectric element 47D via a wiring (not illustrated) provided on the inner surface of the second substrate 46. The terminal 493 is electrically connected to the second electrode 473 of the piezoelectric element 47E through a wiring (not illustrated) provided on the inner surface of the second substrate 46. The terminal 494 is electrically connected to the second electrode 473 of the piezoelectric element 47B via a wiring (not illustrated) provided on the inner surface of the second substrate 46. The terminal 495 is electrically connected to the second electrode 473 of the piezoelectric element 47C via a wiring (not illustrated) provided on the inner surface of the second substrate 46. The terminal 496 is electrically connected to the second electrode 473 of the piezoelectric element 47A by unwinding wiring (not illustrated) provided on the inner surface of the second substrate 46.

On the other hand, the second piezoelectric vibration module 5 includes two terminals 591 and 595 protruding from a base end surface 521 on the base end surface 521 of the support portion 52. The terminal 591 is provided at the first substrate 55 side of the spacer 58 and the terminal 595 is provided at the second substrate 56 side of the spacer 58. The terminals 591 and 595 are disposed at intervals in the third direction Z (width direction of the piezoelectric vibration module 3) without overlapping each other in the second direction Y (thickness direction of the piezoelectric vibration module 3). Also, the terminal 591 is disposed to be juxtaposed with the terminal 491 of the first piezoelectric vibration module 4 in the second direction Y and the terminal 595 is disposed to be juxtaposed with the terminal 495 of the first piezoelectric vibration module 4 in the second direction Y.

The terminal 591 is electrically connected to the first electrode 571 of the piezoelectric element 57 via a wiring (not illustrated) provided on the inner surface of the first substrate 55. The terminal 595 is electrically connected to the second electrode 573 of the piezoelectric element 57 via a wiring (not illustrated) provided on the inner surface of the second substrate 46.

For the piezoelectric vibration module 3 having such a configuration, a wiring board 9 illustrated in Fig. 13 is prepared. The wiring board 9 has a sheet-like base 90 and six wiring lines 91, 92, 93, 94, 94, and 96 disposed on the base 90. The wiring lines 91, 92, 93, 94, 94, and 96 extend in the second direction Y, respectively, and are disposed side by side in the third direction Z. As such a wiring board 9, although not particularly limited, for example, a printed wiring board (flexible wiring board, rigid board, etc.) can be used.

The wiring board 9 is joined to the base end surface 321 of the support portion 32 of the piezoelectric vibration module 3 via an adhesive (not illustrated). With this, the terminals 491 of each first piezoelectric vibration module 4 and the terminal 591 of the second piezoelectric vibration module 5 are electrically connected by the wiring line 91, the terminals 492 of each first piezoelectric vibration module 4 are electrically connected each other by the wiring line 92, the terminals 493 of each first piezoelectric vibration module 4 are electrically connected each other by the wiring line 93, the terminals 494 of each first piezoelectric vibration module 4 are electrically connected each other by the wiring line 94, the terminals 495 of each first piezoelectric vibration module 4 and the terminal 595 of the second piezoelectric vibration module 5 are electrically connected by the wiring line 95, and the terminals 496 of each first piezoelectric vibration module 4 are electrically connected each other by the wiring line 96.

As such, when the terminals to be electrically connected each other are disposed side by side in the second direction Y (thickness direction of the piezoelectric vibration module 3) and the terminals not to be electrically connected each other are disposed to be deviated in the third direction Z (width direction of the piezoelectric vibration module 3), the wiring extending in the second direction Y is used so that electrical connection can be easily performed.

Next, a drive method of the piezoelectric drive device 1 will be described. The piezoelectric drive device 1 has a holding mode for holding the rotor 2 and a drive mode for rotating the rotor 2, and can select any of the holding mode and the drive mode. Selection of the holding mode and the drive mode is performed by the control unit 8.

First, the drive mode will be described. The drive mode is a mode at which piezoelectric vibration module 3 is driven (vibrated) to rotate the rotor 2. In this mode, as illustrated in Fig. 14, the piezoelectric vibration module 3 is driven and the transmission portion 34 is caused to rotationally vibrate. With this, the rotor 2 is sent out by the drive force of the piezoelectric vibration module 3 and the rotor 2 rotates (follows) around the rotation axis O. If the transmission portion 34 is rotationally vibrated in the direction opposite to the direction illustrated in Fig. 14, the rotor 2 can be rotated in the reverse direction.

In this drive mode, the longitudinal vibration generated in the second piezoelectric vibration module 5 substantially does not generate a drive force for rotating the rotor 2. As such, it is possible to suppress excessive increase (more than necessary) of a drive force of the rotor 2 by not using the second piezoelectric vibration module 5 as a driving unit for moving the rotor 2.

Next, the holding mode will be described. The holding mode is a mode for restricting movement of the rotor 2. In this mode, as illustrated in Fig. 15, the piezoelectric vibration module 3 stops driving (vibrating). As described above, each piezoelectric vibration module 3 is urged to the rotor 2 side by the urging portion 7 and the transmission portion 34 is in contact with the upper surface 21 of the rotor 2 with a sufficient frictional force. For that reason, in this state, the rotor 2 is held by the piezoelectric vibration module 3 and rotation (movement) of the rotor 2 is blocked. By having such a holding mode, it is possible to hold the rotor 2 at a predetermined position (rotation angle). Further, unintended movement of the rotor 2 can be suppressed and safety and usability (convenience) of the piezoelectric drive device 1 are improved.

Here, as described above, in the piezoelectric vibration module 3, the longitudinal vibration of the first piezoelectric vibration module 4 and the longitudinal vibration of the second piezoelectric vibration module 5 can make the amplitude of the longitudinal vibration of the transmission portion 34 larger and a pressing force of the piezoelectric vibration module 3 against the rotor 2 can be increased that much of the force. For that reason, in the holding mode, higher holding force of the rotor 2 can be exerted.

The piezoelectric drive device 1 has been described as above. As described above, the piezoelectric drive device 1 includes the vibration portion 31, the piezoelectric vibration module 3 including the transmission portion 34 which abuts the rotor 2 (driven portion) and transmits the vibration of the vibration portion 31 to the rotor 2. The vibration portion 31 includes the vibration portion 41 (first vibration portion) and the vibration portion 51 (second vibration portion) disposed to be stacked in the second direction Y intersecting the first direction X which is a direction in which the vibration portion is aligned with the rotor 2. The vibration portion 41 can perform lateral vibration that vibrates in the third direction Z that intersects the first direction X and the second direction Y. The vibration portion 51 performs longitudinal vibration that vibrates in the first direction X. The transmission portion 34 is configured to perform rotation vibration by combination of lateral vibration of the vibration portion 41 and longitudinal vibration of the vibration portion 51. According to such a configuration, since the rotor 2 is substantially moved only by the vibration of the vibration portion 41, it is possible to suppress excessive increase of a drive force of the rotor 2. Since the rotor 2 is held by both the vibration portion 41 and the vibration portion 51, it is possible to further increase the holding force of the rotor 2. That is, it is possible to obtain the piezoelectric drive device 1 capable of increasing the holding force without excessively increasing the drive force.

The effects described above will be described more clearly based on Figs.16, 17, 18 and 19. Fig. 16 illustrates a piezoelectric vibration module 3' constituted by a stacked body of five first piezoelectric vibration modules 4 as a configuration in the related art, and Fig. 18 illustrates the piezoelectric vibration module 3 of the first embodiment. In both configurations, the coefficient of friction between the piezoelectric vibration module 3 and the rotor 2 is 0.3, 3N is required as the holding force of the rotor 2, and 1.2N is required as the drive force of the rotor 2. An allowable value of the pressing force of the first piezoelectric vibration module 4 to the rotor 2 is 2N and the allowable value of the pressing force of the second piezoelectric vibration module 5 to the rotor 2 is 6N which is three times that of the first piezoelectric vibration module 4. The allowable value is a value at which the pressing force becomes too strong when exceeding the allowable value that makes it difficult to rotate the rotor 2.

In the configuration of the related art illustrated in Fig. 16, as illustrated in the table of Fig. 17, 3N which is the target value of the holding force of the rotor 2 is secured without exceeding the allowable value of each first piezoelectric vibration module 4 by pressing the piezoelectric vibration module 3 against the rotor 2 with a pressing force of 10N. On the other hand, a drive force of the rotor 2 greatly exceeds the target value of 1.2N, and the drive force is 3N. In this case, the drive force of the rotor 2 becomes excessively large (resulting in over-specification), and the piezoelectric drive device 1 becomes difficult to use. Since five first piezoelectric vibration modules 4 are used, the piezoelectric vibration module 3 is increased in size (thicker) and costs are increased than the configuration according to the invention illustrated in Fig. 18.

In contrast, in the configuration according to the invention illustrated in Fig. 18, similarly, as illustrated in the table of Fig. 19, 3N, which is the target value of the holding force of the rotor 2, is secured without exceeding the allowable value of each of the first piezoelectric vibration module 4 and the second piezoelectric vibration module 5, by pressing the piezoelectric vibration module 3 against the rotor 2 with a pressing force of 10N. On the other hand, 1.2N which is the target value is also secured for the drive force of the rotor 2. With this, the holding force and the drive force both become the target values, and the piezoelectric drive device 1 becomes extremely easy to use. Since the piezoelectric vibration module 3 is constituted with two first piezoelectric vibration modules 4 and one second piezoelectric vibration module 5, it is possible to achieve miniaturization (reduction in thickness) and cost reduction of the piezoelectric vibration module 3, in contrast to the configuration of the related art illustrated in Fig. 16. As such, according to the piezoelectric drive device 1, it is possible to increase the holding force without excessively increasing the drive force.

As described above, a drive method of the piezoelectric drive device 1, which includes the piezoelectric vibration module 3 including the vibration portion 31 and the transmission portion 34 which abuts the rotor 2 (driven portion) and transmits vibration of the vibration portion 31 to the rotor 2, is configured to include configuring the vibration portion 31 to include the vibration portion 41 (first vibration portion) and the vibration portion 51 (second vibration portion) disposed side by side in the second direction Y intersecting the first direction X which is a direction in which the vibration portion 31 is aligned with the rotor 2 and causing the transmission portion 34 to rotationally vibrate by causing the second vibration portion 51 to vibrate in the first direction X (longitudinal direction) while causing the vibration portion 41 to vibrate in the third direction Z (lateral direction) intersecting the first direction X and the second direction Y. According to such a drive method, since the rotor 2 is substantially rotated only by the vibration portion 41, it is possible to suppress excessive increase of the drive force of the rotor 2. Since the rotor 2 is held by both the vibration portion 41 and the vibration portion 51, it is possible to further increase the holding force of the rotor 2. That is, it is possible to increase the holding force without excessively increasing the drive force.

Also, as described above, the vibration portion 41 performs composite vibration of lateral vibration in the third direction Z and longitudinal vibration in the first direction X. As such, the vibration portion 41 longitudinally vibrates so as to make it possible to increase the amplitude of the longitudinal vibration of the vibration portion 31 by the synergistic effect with the vibration portion 51. For that reason, it is possible to press the vibration portion 31 against the rotor 2 with a stronger pressing force and to further increase the holding force of the rotor 2.

As described above, when the vibration portion 41 and the vibration portion 51 are individually driven in a state where the transmission portion 34 is not in contact with the rotor 2, the amplitude of the transmission portion 34 in the first direction X due to the longitudinal vibration of the vibration portion 51 is larger than the amplitude of the transmission portion 34 in the first direction X due to the longitudinal vibration of the vibration portion 41. With this, it is possible to make the amplitude of the longitudinal vibration of the transmission portion 34 larger. For that reason, it is possible to press the vibration portion 31 against the rotor 2 with a stronger pressing force, and to further increase the holding force of the rotor 2.

As described above, the vibration portion 41 and the vibration portion 51 have different configurations. With this, it is possible to configure the vibration portion 41 and the vibration portion 51 to have suitable configurations, respectively, so that the piezoelectric drive device 1 capable of performing more efficient driving is obtained. The "different configurations" means that the vibration portion 41 substantially functions as a vibration portion dedicated to lateral vibration and the vibration portion 51 substantially functions as a vibration portion dedicated to longitudinal vibration. In particular, in the first embodiment, the vibration portion 41 and the vibration portion 51 have different configurations each other in that the vibration portion 41 cannot substantially perform longitudinal vibration and the vibration portion 51 can perform longitudinal vibration.

As described above, the area of the vibration region 570 (vibration region 570 of the piezoelectric element 57A) that causes the longitudinal vibration of the vibration portion 51 is larger than the area of the vibration region 470 (vibration region 470 of the piezoelectric element 47C) that causes the longitudinal vibration of the vibration portion 41. For that reason, it is possible to more reliably make the amplitude of the longitudinal vibration of the vibration portion 51 larger than the amplitude of the longitudinal vibration of the vibration portion 41. With this, it is possible to make the amplitude of the longitudinal vibration of the transmission portion 34 larger. For that reason, it is possible to press the vibration portion 31 against the rotor 2 with a stronger pressing force, and to further increase the holding force of the rotor 2.

As described above, the vibration portion 41 and the vibration portion 51 are disposed symmetrically in the second direction Y. With this, it is possible to suppress deflection in the thickness direction at the time of vibrating the vibration portion 31 and to vibrate the transmission portion 34 more efficiently in the XZ plane. For that reason, vibration of the transmission portion 34 can be efficiently transmitted to the rotor 2 via the transmission portion 34, and the rotor 2 can be efficiently rotated.

The configuration of the piezoelectric vibration module 3 is not particularly limited, and for example, modification examples such as those illustrated in Figs.20, 21, and 22 may be included. In each of the modification examples illustrated in Figs.20, 21 and 22, the vibration portion 41 (first piezoelectric vibration module 4) and the vibration portion 51 (second piezoelectric vibration module 5) are disposed symmetrically in the second direction Y, but the invention is not limited thereto and the vibration portion 41 (first piezoelectric vibration module 4) and the vibration portion 51 (second piezoelectric vibration module 5) may be disposed asymmetrically in the second direction Y.

In the embodiment described above, the control unit that controls the piezoelectric vibration module is described as being included in the piezoelectric drive device, but the invention is not limited to the embodiment, and the piezoelectric vibration module may be controlled. The invention can be similarly applied to a structure in which the control device is provided separately from the piezoelectric drive device.

### Second Embodiment

Next, a piezoelectric drive device according to a second embodiment of the invention will be described.

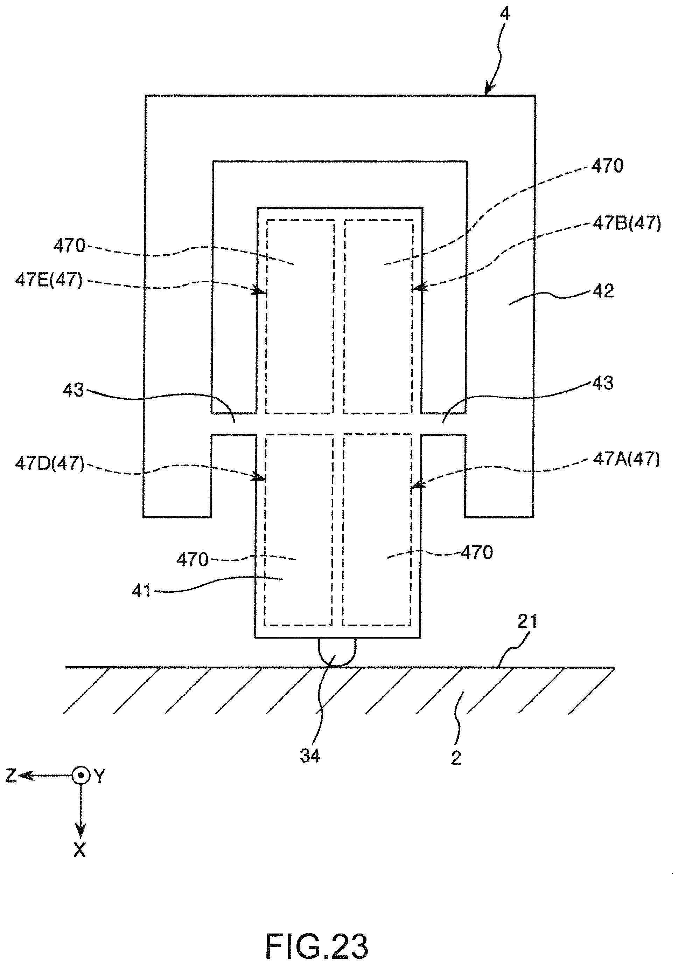

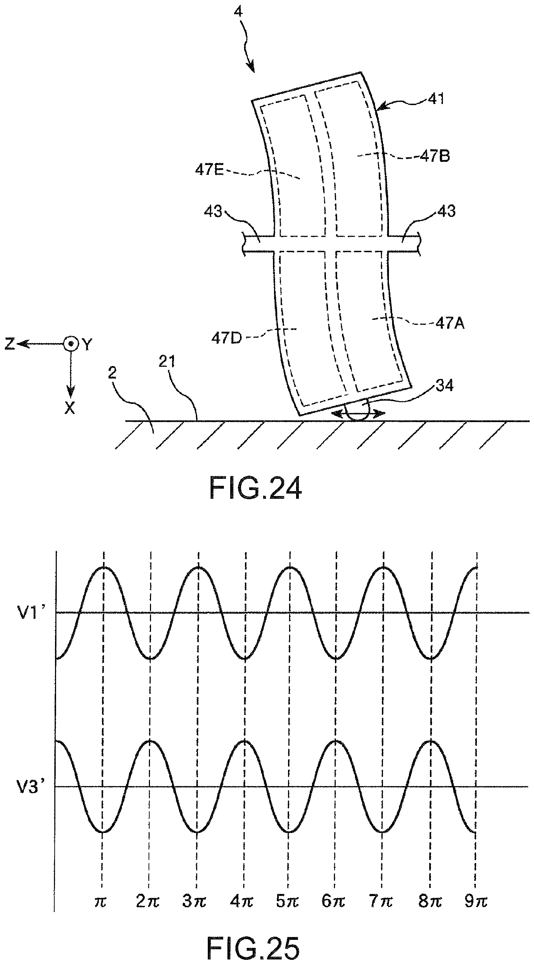

Fig. 23 is a plan view of the first piezoelectric vibration module included in the piezoelectric drive device according to the second embodiment of the invention. Fig. 24 is a view illustrating the vibration state of the first piezoelectric vibration module illustrated in Fig. 23. Fig. 25 is a diagram illustrating a waveform of a voltage applied to the first piezoelectric vibration module.

Hereinafter, the difference between the piezoelectric drive device 1 of the second embodiment and that of the first embodiment described above will be mainly described, and description of similar matters will be omitted.

The piezoelectric drive device 1 according to the second embodiment of the invention is substantially the same as that of the first embodiment described above except that the configuration of the first piezoelectric vibration module 4 is different. The same reference numerals are given to the same configurations as those in the first embodiment described above.

As illustrated in Fig. 23, in the piezoelectric drive device 1 of the second embodiment, the piezoelectric element 47 of the first piezoelectric vibration module 4 includes the piezoelectric elements 47A, 47B, 47D, and 47E. That is, the piezoelectric element 47 has a configuration in which the piezoelectric element 47C is omitted from the configuration of the first embodiment described above. With this, for example, it is possible to reduce the size as compared with the piezoelectric vibration module 3 of the first embodiment described above.

In the first piezoelectric vibration module 4 having such a configuration, as illustrated in Fig. 24, the vibration portion 41 vibrates so as to laterally vibrate the transmission portion 34 in the third direction Z (lateral direction in the figure) . In order to perform such vibration, for example, a voltage V1' illustrated in Fig. 25 is applied to the piezoelectric elements 47A and 47E and a voltage V3' is applied to the piezoelectric elements 47B and 47D. With this, the vibration portion 41 performs lateral vibration that bends at second order in the third direction Z and accordingly, the transmission portion 34 performs lateral vibration. As such, it is possible to cause the transmission portion 34 to laterally vibrate by expanding and contracting the piezoelectric elements 47A and 47E and the piezoelectric elements 47B and 47D, at different phases. However, a voltage pattern to be applied to the first piezoelectric vibration module 4 is not particularly limited as long as it is possible to cause the transmission portion 34 to be laterally vibrated.

As such, in the piezoelectric vibration module 3 of the second embodiment, since the vibration portion 41 does not perform longitudinal vibration, it is possible to cause the vibration portion 31 to rotationally vibrate by combining lateral vibration of the vibration portion 41 and longitudinal vibration of the vibration portion 51 and accordingly, it is possible to rotationally vibrate the transmission portion 34.

According to the second embodiment as described above, it is possible to achieve the same effects as those of the first embodiment described above.

### Third Embodiment

A piezoelectric drive device according to a third embodiment of the invention will be described.

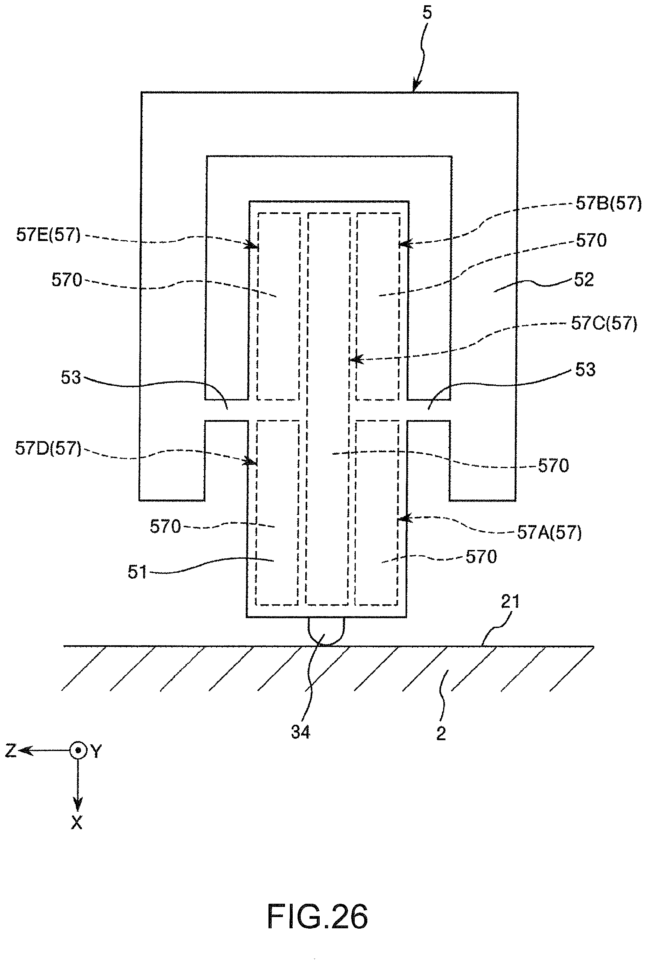

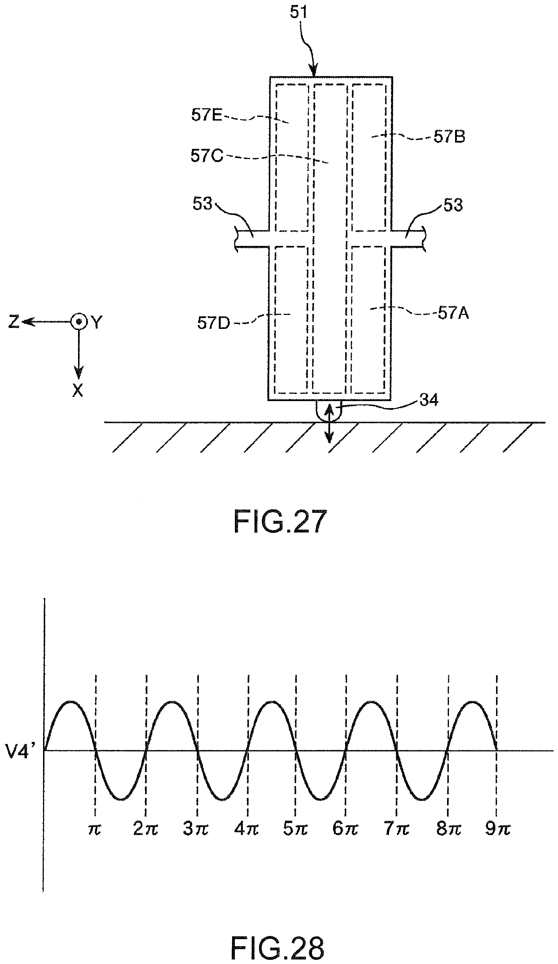

Fig. 26 is a plan view of a second piezoelectric vibration module included in the piezoelectric drive device according to a third embodiment of the invention. Fig. 27 is a diagram illustrating the vibration state of the second piezoelectric vibration module illustrated in Fig. 26. Fig. 28 is a diagram illustrating a waveform of a voltage applied to the second piezoelectric vibration module.

Hereinafter, the difference between the piezoelectric drive device 1 of the third embodiment and that of the embodiments described above will be mainly described, and description of similar matters will be omitted.

The piezoelectric drive device 1 according to the third embodiment of the invention is substantially the same as that of the first embodiment described above except that the configuration of the second piezoelectric vibration module 5 is different. The same reference numerals are given to the same configurations as those in the embodiments described above.

As illustrated in Fig. 26, in the piezoelectric drive device 1 of the third embodiment, the vibration portion 51 (piezoelectric element 57) of the second piezoelectric vibration module 5 has the same configuration as that of the vibration portion 41 (piezoelectric element 47) of the first piezoelectric vibration module 4. Specifically, the piezoelectric element 57 includes five piezoelectric elements 57A, 57B, 57C, 57D, and 57E. Then, the piezoelectric elements 57A and 57B are positioned at one side (right side in Fig. 26) in the width direction of the vibration portion 51 and are disposed side by side in the longitudinal direction of the vibration portion 51. The piezoelectric elements 57D and 57E are positioned at the other side (left side in Fig. 26) in the width direction of the vibration portion 51 and are disposed side by side in the longitudinal direction of the vibration portion 51. The piezoelectric element 57C is positioned at the center portion in the width direction of the vibration portion 51 and is disposed along the longitudinal direction of the vibration portion 51.

In the second piezoelectric vibration module 5 having such a configuration, as illustrated in Fig. 27, the vibration portion 51 vibrates so as to cause the transmission portion 34 to longitudinally vibrate in the first direction X (longitudinal direction in the figure). In order to perform such vibration, for example, a voltage V4' illustrated in Fig. 28 is applied to each of the piezoelectric element 57A, 57B, 57C, 57D, and 57E. With this, the vibration portion 41 performs longitudinal vibration that expands and contracts in the first direction X and accordingly, the transmission portion 34 performs longitudinal vibration. As such, it is possible to cause the transmission portion 34 to vibrate longitudinally, easily and reliably by expanding and contracting all the piezoelectric elements 57A, 57B, 57C, 57D, and 57E at the same phase. However, the voltage pattern to be applied to the piezoelectric element 57 is not particularly limited as long as it is possible to longitudinally vibrate the transmission portion 34.

Each of the piezoelectric elements 57A, 57B, 57C, 57D, and 57E is connected to a terminal 595 via a wiring disposed on the inner surface of the second substrate 56, and has the same potential. For that reason, it becomes easy to apply the voltage V4' as described above to the piezoelectric elements 57A, 57B, 57C, 57D, and 57E.

The piezoelectric drive device 1 of the third embodiment has been described as above. In the piezoelectric drive device 1 as described above, the vibration portion 41 (first vibration portion) and the vibration portion 51 (second vibration portion) have the same configuration. With this, it is possible to make parts common in the vibration portion 41 and the vibration portion 51 and it is possible to reduce the cost of the piezoelectric vibration module 3. The "same configuration as each other" means that both the vibration portion 41 and the vibration portion 51 can perform lateral vibration and longitudinal vibration.

As described above, each of the vibration portion 41 and the vibration portion 51 has at least one pair of vibration regions disposed side by side in the third direction Z. For example, in the vibration portion 41, the vibration region 470 of the piezoelectric element 47A and the vibration region 470 of the piezoelectric element 47D are provided, and in the vibration portion 51, the vibration region 570 of the piezoelectric element 57A and the vibration region 570 of the piezoelectric element 57D are provided. Then, in the vibration portion 41, lateral vibration is performed by expanding and contracting the pair of vibration regions 470 at different phases, and in the vibration portion 51, longitudinal vibration is performed by expanding and contracting the pair of vibration regions 570 at the same phase. With this, it is possible to laterally vibrate the vibration portion 41 and to longitudinally vibrate the vibration portion 51 with a simple structure.

### Fourth Embodiment

Next, a piezoelectric drive device according to a fourth embodiment of the invention will be described.

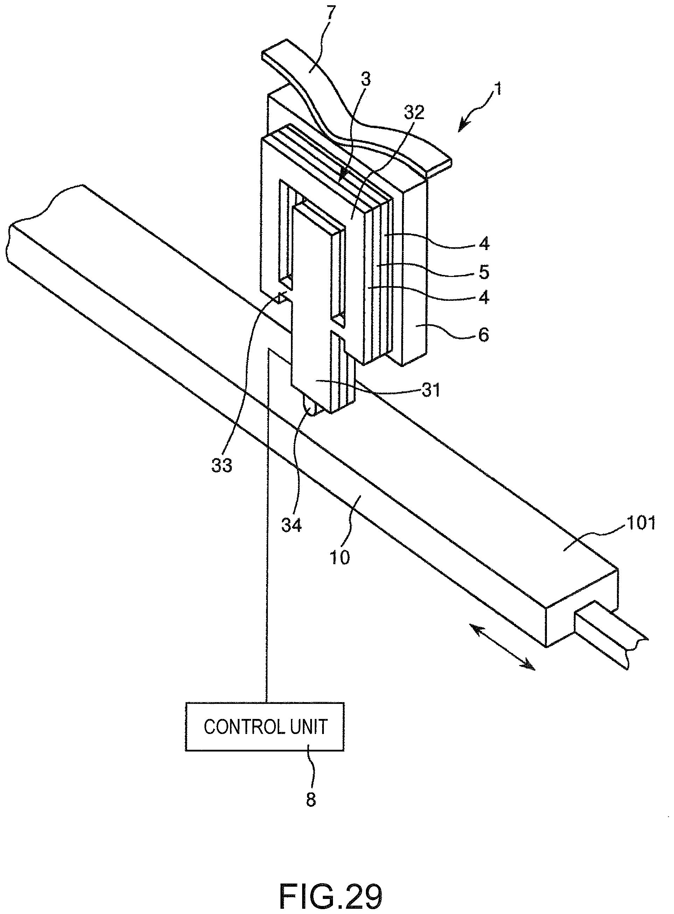

Fig. 29 is a perspective view illustrating a piezoelectric drive device according to the fourth embodiment of the invention.

Hereinafter, the difference between the piezoelectric drive device 1 of the fourth embodiment and that of the embodiments described above will be mainly described, and description of similar matters will be omitted.

The piezoelectric drive device according to the fourth embodiment of the invention is substantially the same as in the first embodiment described above except that the configuration of the driven portion is different. The same reference numerals are given to the same configurations as those in the embodiments described above.

As illustrated in Fig. 29, the piezoelectric drive device 1 of the fourth embodiment is used as a linear motion motor, and includes a slider 10 (driven portion) linearly movable, a piezoelectric vibration module 3 that abuts on the upper surface 101 of the slider 10, a stage 6 that supports the piezoelectric vibration module 3, an urging portion 7 that urges the piezoelectric vibration module 3 toward the slider 10 via the stage 6, a control unit 8 that controls driving of the piezoelectric vibration module 3. Also, in the piezoelectric drive device 1 having such a configuration, similarly as in the first embodiment described above, the slider 10 can be moved by rotationally vibrating the transmission portion 34 at the drive mode and the slider 10 can be held by pressing the transmission portion 34 against the slider 10 at the holding mode.

According to the fourth embodiment described above, it is possible to achieve the same effects as those in the first embodiment described above.

### Fifth Embodiment

Next, a robot according to a fifth embodiment of the invention will be described.

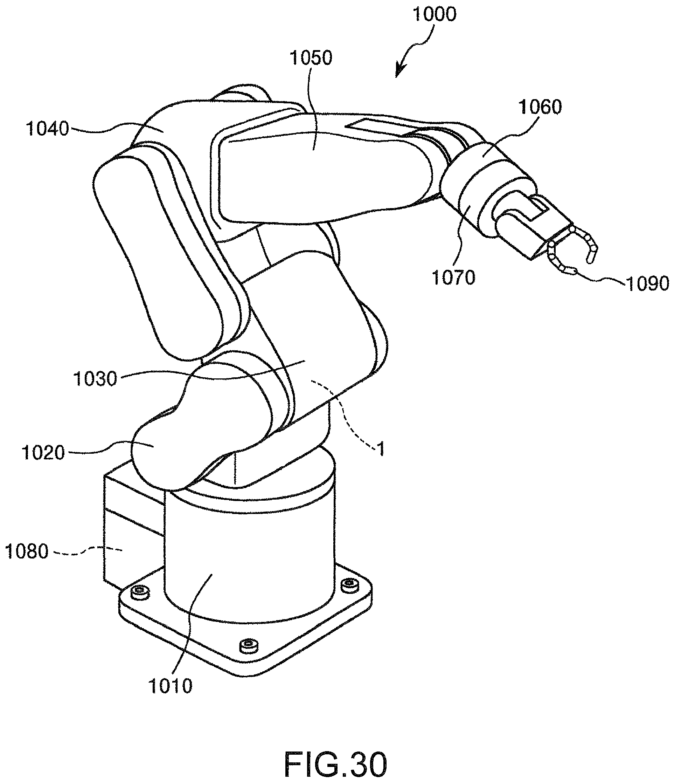

Fig. 30 is a perspective view illustrating a robot according to a fifth embodiment of the invention.

A robot 1000 illustrated in Fig. 30 can perform work such as feeding of material, removing of material, transporting of material, and assembling of material for precision equipment and parts constituting the precision equipment. The robot 1000 is a six-shaft robot, and includes a base 1010 fixed to a floor or a ceiling, an arm 1020 rotatably connected to the base 1010, an arm 1030 rotatably connected to the arm 1020, an arm 1040 rotatably connected to the arm 1030, an arm 1050 rotatably connected to the arm 1040, an arm 1060 rotatably connected to the arm 1050, an arm 1070 rotatably connected to the arm 1060, and a robot control unit 1080 for controlling driving of the arms 1020, 1030, 1040, 1050, 1060, and 1070. A hand connection portion is provided on the arm 1070, and an end effector 1090 according to the work to be executed by the robot 1000 is mounted on the hand connection portion. The piezoelectric drive device 1 is mounted on all or some of the respective joint portions, and the arms 1020, 1030, 1040, 1050, 1060, and 1070 are rotated by driving of the piezoelectric drive device 1. Driving of each piezoelectric drive device 1 is controlled by the robot control unit 1080. In addition, the piezoelectric drive device 1 may be mounted on the end effector 1090 and used for driving the end effector 1090.

Such a robot 1000 has the piezoelectric drive device 1. For that reason, it is possible to achieve the effects of the piezoelectric drive device 1 described above and to exhibit high reliability.

### Sixth Embodiment

Next, an electronic component transport apparatus according to a sixth embodiment of the invention will be described.

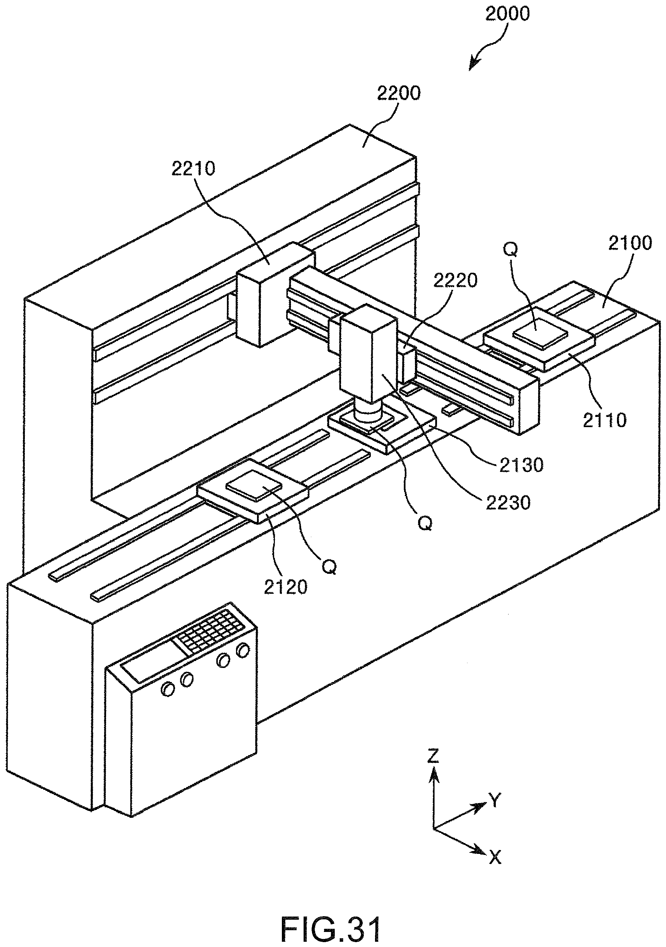

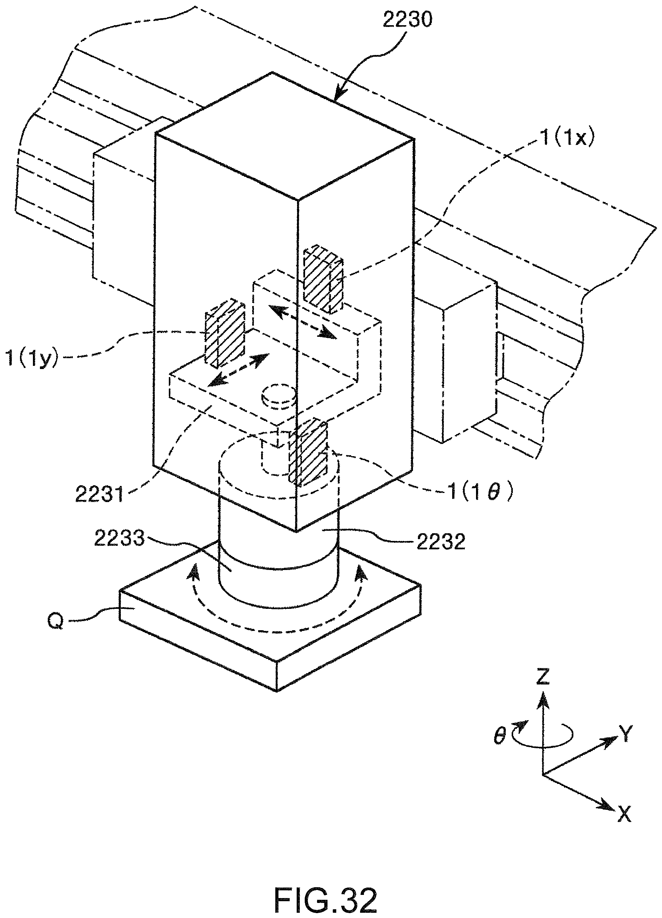

Fig. 31 is a perspective view illustrating an electronic component transport apparatus according to a sixth embodiment of the invention. Fig. 32 is a perspective view illustrating an electronic component holding unit included in the electronic component transport apparatus illustrated in Fig. 31. In the following description, three axes orthogonal to each other are referred to as an X-axis, a Y-axis, and a Z-axis for convenience of explanation.

An electronic component transport apparatus 2000 illustrated in Fig. 31 is applied to an electronic component inspection apparatus, and includes a base 2100 and a support stand 2200 disposed on a side of the base 2100. Further, on the base 2100, an upstream stage 2110 on which an electronic component Q to be inspected is mounted and transported in the Y-axis direction and a downstream stage 2120 on which an inspected electronic component Q is mounted and transported in the Y-axis direction, and an inspection table 2130 which is positioned between the upstream stage 2110 and the downstream stage 2120 and on which electrical characteristics of the electronic component Q is inspected are provided. Examples of the electronic component Q include a semiconductor, a semiconductor wafer, a display device such as a CLD and an OLED, a quartz crystal device, various sensors, an ink jet head, various MEMS devices, and the like.

A Y-stage 2210 movable in the Y axis direction with respect to the support stand 2200 is provided on the support stand 2200, an X-stage 2220 movable in the X-axis direction with respect to the Y-stage 2210 is provided on the Y-stage 2210, and an electronic component holding unit 2230 movable in the Z-axis direction with respect to the X-stage 2220 is provided on the X-stage 2220.

As illustrate in Fig. 32, the electronic component holding unit 2230 includes a fine adjustment plate 2231 movable in the X axis direction and the Y axis direction, and a rotating portion 2232 rotatable about the Z-axis with respect to the fine adjustment plate 2231, and a holding unit 2233 which is provided in the rotating portion 2232 and holds the electronic component Q. The electronic component holding unit 2230 is provided with the piezoelectric drive device 1 (1x) for moving the fine adjustment plate 2231 in the X-axis direction, the piezoelectric drive device 1 (1y) for moving the fine adjustment plate 2231 in the Y-axis direction, and the piezoelectric drive device 1 (1θ) for rotating the rotating portion 2232 around the Z-axis. As the piezoelectric drive devices 1x and 1y, those of the fourth embodiment described above can be used and as the piezoelectric drive device 1θ described above, those of the first, second, and third embodiments can be used.

Such an electronic component transport apparatus 2000 includes the piezoelectric drive device 1. For that reason, it is possible to achieve the effects of the piezoelectric drive device 1 described above and to exhibit high reliability.

### Seventh Embodiment

Next, a printer according to a seventh embodiment of the invention will be described.

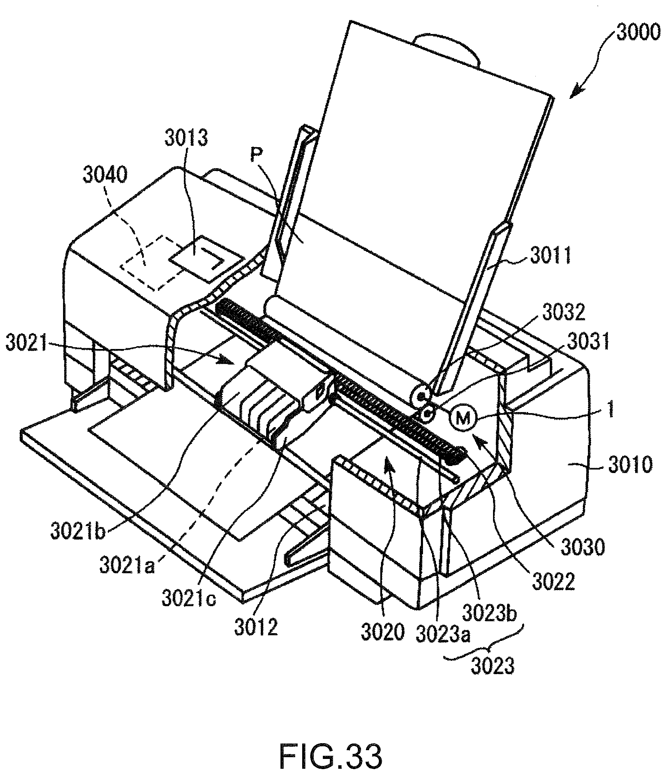

Fig. 33 is a schematic diagram illustrating the overall configuration of a printer according to a seventh embodiment of the invention.

A printer 3000 illustrated in Fig. 33 includes an apparatus main body 3010, a printing mechanism 3020 provided inside the apparatus main body 3010, a sheet feed mechanism 3030, and a control unit 3040. The apparatus main body 3010 is provided with a tray 3011 for placing a recording sheet P, a sheet discharge port 3012 for discharging the recording sheet P, and an operation panel 3013 such as a liquid crystal display.

The printing mechanism 3020 includes a head unit 3021, a carriage motor 3022, and a reciprocating mechanism 3023 for reciprocating the head unit 3021 by a drive force of the carriage motor 3022. The head unit 3021 includes a head 3021a which is an ink jet type recording head, an ink cartridge 3021b which supplies ink to the head 3021a, and a carriage 3021c on which the head 3021a and the ink cartridge 3021b are mounted.

The reciprocating mechanism 3023 includes a carriage guide shaft 3023a which reciprocatably supports the carriage 3021c and a timing belt 3023b for moving the carriage 3021c on the carriage guide shaft 3023a by the drive force of the carriage motor 3022.

The sheet feed mechanism 3030 includes a driven roller 3031 and a driving roller 3032 that are in pressure contact with each other and a piezoelectric drive device 1 that is a sheet feeding motor that drives the driving roller 3032.

The control unit 3040 controls the printing mechanism 3020, the sheet feed mechanism 3030, and the like based on print data input from a host computer such as a personal computer.

In such a printer 3000, the sheet feed mechanism 3030 intermittently feeds the recording paper P one by one to the vicinity of the lower portion of the head unit 3021. At this time, the head unit 3021 reciprocates in a direction substantially orthogonal to the feeding direction of the recording paper P and printing on the recording paper P is performed.

Such a printer 3000 includes the piezoelectric drive device 1. For that reason, it is possible to achieve the effects of the piezoelectric drive device 1 described above and to exhibit high reliability. In the seventh embodiment, the piezoelectric drive device 1 drives the driving roller 3032, but in addition to this, for example, may also drive the carriage 3021c.

### Eighth Embodiment

Next, a projector according to an eighth embodiment of the invention will be described.

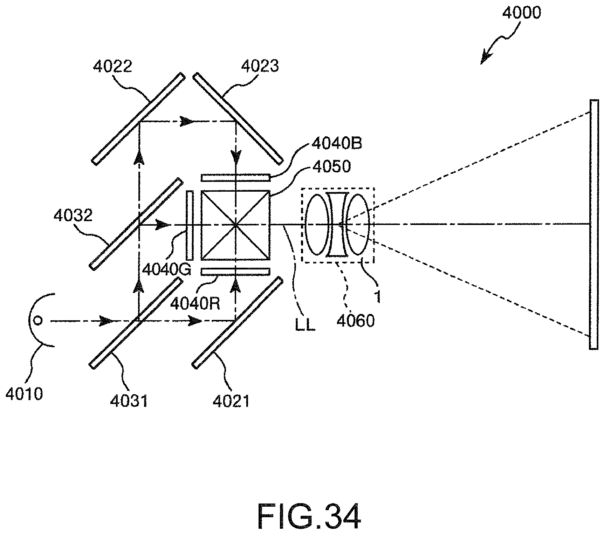

Fig. 34 is a schematic diagram illustrating the overall configuration of a projector according to an eighth embodiment of the invention.

A projector 4000 illustrated in Fig. 34 is an LCD type projector and includes a light source 4010, mirrors 4021, 4022, and 4023, dichroic mirrors 4031 and 4032, liquid crystal display elements 4040R, 4040G, 4040B, a dichroic prism 4050, a projection lens system 4060, and the piezoelectric drive device 1.

As the light source 4010, for example, a halogen lamp, a mercury lamp, a light emitting diode (LED), and the like are included. As the light source 4010, one that emits white light is used. Then, light emitted from the light source 4010 is first separated into red light (R) and other light beams by the dichroic mirror 4031. After being reflected by the mirror 4021, red light enters the liquid crystal display element 4040R, and the other light beams are further separated into green light (G) and blue light (B) by the dichroic mirror 4032. Then, green light enters the liquid crystal display element 4040G and blue light is reflected by the mirrors 4022 and 4023 and then enters the liquid crystal display element 4040B.

Each of the liquid crystal display elements 4040R, 4040G, 4040B is used as a spatial light modulator. These liquid crystal display elements 4040R, 4040G, and 4040B are transmissive spatial light modulators corresponding to primary colors of R, G, and B, respectively, and have pixels arrayed in a matrix of, for example, 1080 rows in the vertical direction and 1920 columns in the horizontal direction. In each pixel, an amount of transmitted light with respect to incident light is adjusted, and light amount distribution of all the pixels is cooperatively controlled in each of the liquid crystal display elements 4040R, 4040G, and 4040B. Light beams spatially modulated by the liquid crystal display elements 4040R, 4040G, and 4040B are synthesized in the dichroic prism 4050, and full color image light LL is emitted from the dichroic prism 4050. Then, the emitted projected image light LL is enlarged and projected onto, for example, a screen or the like, by the projection lens system 4060. The piezoelectric drive device 1 can change a focal length by moving at least one lens included in the projection lens system 4060 in an optical axis direction.

Such a projector 4000 includes the piezoelectric drive device 1. For that reason, it is possible to achieve the effects of the piezoelectric drive device 1 described above and to exhibit high reliability.

Although the piezoelectric drive device, the drive method of the piezoelectric drive device, the robot, the electronic component transport apparatus, the printer, and the projector according to the invention have been described based on the illustrated embodiments, the invention is not limited thereto and the configuration of each of the portions and units can be replaced with any configuration having the same function.

In the embodiments described above, although the configurations in which the piezoelectric drive device is applied to the robot, the electronic component transport apparatus, the printer, and the projector are described, the piezoelectric drive device can also be applied to various electronic devices other than those described above.

## Claims

1. A piezoelectric drive device (1) comprising:
a piezoelectric vibration module (3) including a vibration portion (31) and a transmission portion (34) which abuts a driven portion (2), which is a rotor, and is adapted to transmit vibration of the vibration portion (31) to the driven portion (2); and
a control unit (8),
wherein the vibration portion (31) includes a first vibration portion (41) and a second vibration portion (51) disposed to be stacked in a second direction (Y) intersecting a first direction (X) which is a direction in which the vibration portion (31) is aligned with the driven portion (2),
wherein the piezoelectric vibration module (3) includes a first piezoelectric vibration module (4) and a second piezoelectric vibration module (5) stacked in the second direction (Y), the first piezoelectric vibration module (4) being disposed in a pair so as to sandwich the second piezoelectric vibration module (5) therebetween,
wherein the first piezoelectric vibration module (4) includes the first vibration portion (41) and the second vibration module (5) includes the second vibration portion (51), and
the control unit (8) is configured to cause the first vibration portion (41) to perform lateral vibration to vibrate in a third direction (Z) intersecting the first direction (X) and the second direction (Y), and is configured to cause the second vibration portion (51) to perform longitudinal vibration to vibrate in the first direction (X),
wherein the control unit (8) is adapted to cause the first vibration portion (41) to perform composite vibration of vibration in the third direction (Z) and vibration in the first direction (X), and
the transmission portion (34) is configured to perform rotation vibration by combination of lateral vibration of the first vibration portion (41) and longitudinal vibration of the second vibration portion (51), such that, in use, the driven portion (2) is substantially moved only by the vibration of the first vibration portion (41), and the driven portion (2) is held by both the first vibration portion (41) and the second vibration portion (51).

2. The piezoelectric drive device (1) according to Claim 1,
wherein in a case where the control unit (8) is adapted to individually drive the first vibration portion (41) and the second vibration portion (51) in a state where the transmission portion (34) is not in contact with the driven portion (2), amplitude of the transmission portion (34) in the first direction (X) due to the vibration of the second vibration portion (51) in the first direction (X) is larger than the amplitude of the transmission portion (34) in the first direction (X) due to the vibration of the first vibration portion (41) in the first direction (X).

3. The piezoelectric drive device (1) according to Claim 1 or 2,
wherein the first vibration portion (41) and the second vibration portion (51) have different configurations.

4. The piezoelectric drive device (1) according to Claim 3,
wherein an area of a vibration region in which the vibration of the second vibration portion (51) in the first direction (X) is adapted to be caused is larger than an area of the vibration region in which the vibration of the first vibration portion (41) in the first direction (X) is adapted to be caused.

5. The piezoelectric drive device (1) according to any one of the preceding claims,
wherein the first vibration portion (41) and the second vibration portion (51) have the same configuration,
the first vibration portion (41) and the second vibration portion (51) have at least one pair of vibration regions disposed side by side in the third direction (Z), and
the control unit (8) is adapted to cause the first vibration portion (41) to vibrate in the third direction (Z) by expanding and contracting the pair of vibration regions at different phases, and is adapted to cause the second vibration portion (51) to vibrate in the first direction (X) by expanding and contracting the pair of vibration regions at the same phase.

6. The piezoelectric drive device (1) according to any one of the preceding claims,
wherein the first vibration portion (41) and the second vibration portion (51) are disposed symmetrically in the second direction (Y).

7. A drive method of a piezoelectric drive device (1), which includes a piezoelectric vibration module (3) including a vibration portion (31) and a transmission portion (34) which abuts a driven portion (2), which is a rotor, and transmits vibration of the vibration portion (31) to the driven portion (2), the method comprising:
configuring the vibration portion (31) to include a first vibration portion (41) and a second vibration portion (51) disposed side by side in a second direction (Y) intersecting a first direction (X) which is a direction in which the vibration portion is aligned with the driven portion (2);
configuring the piezoelectric vibration module (3) to include a first piezoelectric vibration module (4) and a second piezoelectric vibration module (5) stacked in the second direction (Y), the first piezoelectric vibration module (4) being disposed in a pair so as to sandwich the second piezoelectric vibration module (5) therebetween, wherein the first piezoelectric vibration module (4) includes the first vibration portion (41) and the second vibration module (5) includes the second vibration portion (51), and
causing the transmission portion (34) to rotationally vibrate by causing the second vibration portion (51) to perform longitudinal vibration to vibrate in the first direction (X) while causing the first vibration portion (41) to perform lateral vibration to vibrate in a third direction (Z) intersecting the first direction (X) and the second direction (Y),
wherein the control unit (8) causes the first vibration portion (41) to perform composite vibration of vibration in the third direction (Z) and vibration in the first direction (X), and
the transmission portion (34) performs rotation vibration by combination of lateral vibration of the first vibration portion (41) and longitudinal vibration of the second vibration portion (51), such that the driven portion (2) is substantially moved only by the vibration of the first vibration portion (41), and the driven portion (2) is held by both the first vibration portion (41) and the second vibration portion (51).

8. A robot (1000) comprising:
the piezoelectric drive device (1) according to any one of claims 1 to 6.

9. An electronic component transport apparatus (2000) comprising:
the piezoelectric drive device (1) according to Claim 1.

10. A printer (3000) comprising:
the piezoelectric drive device (1) according to any one of claims 1 to 6.

11. A projector (4000) comprising:
the piezoelectric drive device (1) according to any one of claims 1 to 6.

## Patentansprüche

1. Piezoelektrische Antriebsvorrichtung (1), umfassend: ein piezoelektrisches Schwingungsmodul (3) einschließlich eines Schwingungsabschnitts (31) und eines Übertragungsabschnitts (34), der an einen angetriebenen Abschnitt (2) angrenzt, der ein Rotor ist und zur Übertragung von Schwingungen des Schwingungsabschnitts (31) auf den angetriebenen Abschnitt (2) ausgelegt ist; und
eine Steuereinheit (8),
wobei der Schwingungsabschnitt (31) einen ersten Schwingungsabschnitt (41) und einen zweiten Schwingungsabschnitt (51) einschließt, die angeordnet sind, um in einer zweiten Richtung (Y) gestapelt zu werden, die eine erste Richtung (X) schneidet, die eine Richtung ist, in welcher der Schwingungsabschnitt (31) mit dem angetriebenen Abschnitt (2) ausgerichtet ist,
wobei das piezoelektrische Schwingungsmodul (3) ein erstes piezoelektrisches Schwingungsmodul (4) und ein zweites piezoelektrisches Schwingungsmodul (5) einschließt, das in der zweiten Richtung (Y) gestapelt ist, wobei das erste piezoelektrische Schwingungsmodul (4) in einem Paar angeordnet ist, um das zweite piezoelektrische Schwingungsmodul (5) dazwischen aufzunehmen,
wobei das erste piezoelektrische Schwingungsmodul (4) den ersten Schwingungsabschnitt (41) einschließt und das zweite Schwingungsmodul (5) den zweiten Schwingungsabschnitt (51) einschließt und
die Steuereinheit (8) konfiguriert ist, um zu bewirken, dass der erste Schwingungsabschnitt (41) eine laterale Schwingung durchführt, um in einer dritten Richtung (Z) zu schwingen, welche die erste Richtung (X) und die zweite Richtung (Y) schneidet, und konfiguriert ist, um zu bewirken, dass der zweite Schwingungsabschnitt (51) eine Längsschwingung durchführt, um in der ersten Richtung (X) zu schwingen,
wobei die Steuereinheit (8) ausgelegt ist, um zu bewirken, dass der erste Schwingungsabschnitt (41) eine zusammengesetzte Schwingung der Schwingung in der dritten Richtung (Z) und der Schwingung in der ersten Richtung (X) durchführt und
der Übertragungsabschnitt (34) konfiguriert ist, um eine Rotationsschwingung durch Kombination einer lateralen Schwingung des ersten Schwingungsabschnitts (41) und einer Längsschwingung des zweiten Schwingungsabschnitts (51) durchzuführen, so dass im Gebrauch der angetriebene Abschnitt (2) im Wesentlichen nur durch die Schwingung des ersten Schwingungsabschnitts (41) bewegt wird und der angetriebene Abschnitt (2) sowohl vom ersten Schwingungsabschnitt (41) als auch vom zweiten Schwingungsabschnitt (51) gehalten wird.

2. Piezoelektrische Antriebsvorrichtung (1) nach Anspruch 1,
wobei in einem Fall, in dem die Steuereinheit (8) ausgelegt ist, um den ersten Schwingungsabschnitt (41) und den zweiten Schwingungsabschnitt (51) einzeln in einem Zustand anzutreiben, in dem der Übertragungsabschnitt (34) nicht mit dem angetriebenen Abschnitt (2) in Kontakt steht, die Amplitude des Übertragungsabschnitts (34) in der ersten Richtung (X) aufgrund der Schwingung des zweiten Schwingungsabschnitts (51) in der ersten Richtung (X) größer als die Amplitude des Übertragungsabschnitts (34) in der ersten Richtung (X) aufgrund der Schwingung des ersten Schwingungsabschnitts (41) in der ersten Richtung (X) ist.

3. Piezoelektrische Antriebsvorrichtung (1) nach Anspruch 1 oder 2,
wobei der erste Schwingungsabschnitt (41) und der zweite Schwingungsabschnitt (51) unterschiedliche Konfigurationen aufweisen.

4. Piezoelektrische Antriebsvorrichtung (1) nach Anspruch 3,
wobei ein Bereich einer Schwingungsregion, in der die Schwingung des zweiten Schwingungsabschnitts (51) in der ersten Richtung (X) ausgelegt ist, um bewirkt zu werden, größer ist als ein Bereich der Schwingungsregion, in der die Schwingung des ersten Schwingungsabschnitts (41) in der ersten Richtung (X) ausgelegt ist, um bewirkt zu werden.

5. Piezoelektrische Antriebsvorrichtung (1) nach einem der vorstehenden Ansprüche,
wobei der erste Schwingungsabschnitt (41) und der zweite Schwingungsabschnitt (51) die gleiche Konfiguration aufweisen,
der erste Schwingungsabschnitt (41) und der zweite Schwingungsabschnitt (51) mindestens ein Paar von Schwingungsregionen aufweisen, die nebeneinander in der dritten Richtung (Z) angeordnet sind und
die Steuereinheit (8) ausgelegt ist, um zu bewirken, dass der erste Schwingungsabschnitt (41) in der dritten Richtung (Z) durch Ausdehnen und Zusammenziehen des Paares von Schwingungsregionen in unterschiedlichen Phasen schwingt, und ausgelegt ist, um zu bewirken, dass der zweite Schwingungsabschnitt (51) in der ersten Richtung (X) durch Ausdehnen und Zusammenziehen des Paares von Schwingungsregionen in derselben Phase schwingt.

6. Piezoelektrische Antriebsvorrichtung (1) nach einem der vorstehenden Ansprüche,
wobei der erste Schwingungsabschnitt (41) und der zweite Schwingungsabschnitt (51) symmetrisch in der zweiten Richtung (Y) angeordnet sind.

7. Antriebsverfahren einer piezoelektrischen Antriebsvorrichtung (1), die ein piezoelektrisches Schwingungsmodul (3) einschließlich eines Schwingungsabschnitts (31) und eines Übertragungsabschnitts (34) einschließt, der an einen angetriebenen Abschnitt (2) angrenzt, der ein Rotor ist und Schwingung des Schwingungsabschnitts (31) auf den angetriebenen Abschnitt (2) überträgt, wobei das Verfahren umfasst:
Konfigurieren des Schwingungsabschnitts (31), um einen ersten Schwingungsabschnitt (41) und einen zweiten Schwingungsabschnitt (51) einzuschließen, die nebeneinander in einer zweiten Richtung (Y) angeordnet sind, die eine erste Richtung (X) schneidet, die eine Richtung ist, in welcher der Schwingungsabschnitt mit dem angetriebenen Abschnitt (2) ausgerichtet ist;
Konfigurieren des piezoelektrischen Schwingungsmoduls (3), um ein erstes piezoelektrisches Schwingungsmodul (4) und ein zweites piezoelektrisches Schwingungsmodul (5) einzuschließen, die in der zweiten Richtung (Y) gestapelt sind, wobei das erste piezoelektrische Schwingungsmodul (4) in einem Paar angeordnet ist, um das zweite piezoelektrische Schwingungsmodul (5) dazwischen aufzunehmen, wobei das erste piezoelektrische Schwingungsmodul (4) den ersten Schwingungsabschnitt (41) einschließt und das zweite Schwingungsmodul (5) den zweiten Schwingungsabschnitt (51) einschließt und
Bewirken, dass der Übertragungsabschnitt (34) rotierend schwingt, durch Bewirken, dass der zweite Schwingungsabschnitt (51) eine Längsschwingung ausführt, um in der ersten Richtung (X) zu schwingen, indem er gleichzeitig bewirkt, dass der erste Schwingungsabschnitt (41) eine laterale Schwingung durchführt, um in einer dritten Richtung (Z) zu schwingen, welche die erste Richtung (X) und die zweite Richtung (Y) schneidet,
wobei die Steuereinheit (8) bewirkt, dass der erste Schwingungsabschnitt (41) eine zusammengesetzte Schwingung der Schwingung in der dritten Richtung (Z) und der Schwingung in der ersten Richtung (X) durchführt und
der Übertragungsabschnitt (34) eine Rotationsschwingung durch Kombination einer lateralen Schwingung des ersten Schwingungsabschnitts (41) und einer Längsschwingung des zweiten Schwingungsabschnitts (51) durchführt, so dass der angetriebene Abschnitt (2) im Wesentlichen nur durch die Schwingung des ersten Schwingungsabschnitts (41) bewegt wird und der angetriebene Abschnitt (2) sowohl vom ersten Schwingungsabschnitt (41) als auch vom zweiten Schwingungsabschnitt (51) gehalten wird.

8. Roboter (1000), umfassend:
die piezoelektrische Antriebsvorrichtung (1) nach einem der Ansprüche 1 bis 6.

9. Transporteinrichtung für elektronische Komponenten (2000), umfassend:
die piezoelektrische Antriebsvorrichtung (1) nach Anspruch 1.

10. Drucker (3000), umfassend:
die piezoelektrische Antriebsvorrichtung (1) nach einem der Ansprüche 1 bis 6.

11. Projektor (4000), umfassend:
die piezoelektrische Antriebsvorrichtung (1) nach einem der Ansprüche 1 bis 6.

## Revendications

1. Dispositif d'entraînement piézoélectrique (1) comprenant :
un module de vibration piézoélectrique (3) incluant une partie de vibration (31) et une partie de transmission (34) qui bute contre une partie entraînée (2), qui est un rotor, et est adapté pour transmettre la vibration de la partie de vibration (31) à la partie entraînée (2) ; et
une unité de commande (8),
dans lequel la partie de vibration (31) inclut une première partie de vibration (41) et une seconde partie de vibration (51) disposées pour être empilées dans une deuxième direction (Y) coupant une première direction (X) qui est une direction dans laquelle la partie de vibration (31) est alignée avec la partie entraînée (2),
dans lequel le module de vibration piézoélectrique (3) inclut un premier module de vibration piézoélectrique (4) et un second module de vibration piézoélectrique (5) empilés dans la deuxième direction (Y), le premier module de vibration piézoélectrique (4) étant disposé en une paire de manière à prendre en sandwich le second module de vibration piézoélectrique (5) entre elle,
dans lequel le premier module de vibration piézoélectrique (4) inclut la première partie de vibration (41) et le second module de vibration (5) inclut la seconde partie de vibration (51), et
l'unité de commande (8) est configurée pour amener la première partie de vibration (41) à effectuer une vibration latérale pour vibrer dans une troisième direction (Z) coupant la première direction (X) et la deuxième direction (Y), et est configurée pour amener la seconde partie de vibration (51) à effectuer une vibration longitudinale pour vibrer dans la première direction (X),
dans lequel l'unité de commande (8) est adaptée pour amener la première partie de vibration (41) à effectuer une vibration composite de vibration dans la troisième direction (Z) et de vibration dans la première direction (X), et
la partie de transmission (34) est configurée pour effectuer une vibration en rotation en combinant une vibration latérale de la première partie de vibration (41) et une vibration longitudinale de la seconde partie de vibration (51) de sorte que, lors de l'utilisation, la partie entraînée (2) est sensiblement déplacée uniquement par la vibration de la première partie de vibration (41), et la partie entraînée (2) est maintenue à la fois par la première partie de vibration (41) et la seconde partie de vibration (51).

2. Dispositif d'entraînement piézoélectrique (1) selon la revendication 1,
dans lequel, dans un cas où l'unité de commande (8) est adaptée pour entraîner individuellement la première partie de vibration (41) et la seconde partie de vibration (51) dans un état où la partie de transmission (34) n'est pas en contact avec la partie entraînée (2), l'amplitude de la partie de transmission (34) dans la première direction (X) due à la vibration de la seconde partie de vibration (51) dans la première direction (X) est supérieure à l'amplitude de la partie de transmission (34) dans la première direction (X) due à la vibration de la première partie de vibration (41) dans la première direction (X).

3. Dispositif d'entraînement piézoélectrique (1) selon la revendication 1 ou 2,
dans lequel la première partie de vibration (41) et la seconde partie de vibration (51) présentent des configurations différentes.

4. Dispositif d'entraînement piézoélectrique (1) selon la revendication 3,
dans lequel une zone d'une région de vibration dans laquelle la vibration de la seconde partie de vibration (51) dans la première direction (X) est adaptée pour être amenée est supérieure à une zone de la région de vibration dans laquelle la vibration de la première partie de vibration (41) dans la première direction (X) est adaptée pour être amenée.

5. Dispositif d'entraînement piézoélectrique (1) selon l'une quelconque des revendications précédentes,
dans lequel la première partie de vibration (41) et la seconde partie de vibration (51) présentent la même configuration,
la première partie de vibration (41) et la seconde partie de vibration (51) présentent au moins une paire de régions de vibration disposées côte à côte dans la troisième direction (Z), et
l'unité de commande (8) est adaptée pour amener la première partie de vibration (41) à vibrer dans la troisième direction (Z) en dilatant et en contractant la paire de régions de vibration à différentes phases, et est adaptée pour amener la seconde partie de vibration (51) à vibrer dans la première direction (X) en dilatant et en contractant la paire de régions de vibration à la même phase.

6. Dispositif d'entraînement piézoélectrique (1) selon l'une quelconque des revendications précédentes,
dans lequel la première partie de vibration (41) et la seconde partie de vibration (51) sont disposées symétriquement dans la deuxième direction (Y).

7. Procédé d'entraînement d'un dispositif d'entraînement piézoélectrique (1), qui inclut un module de vibration piézoélectrique (3) incluant une partie de vibration (31) et une partie de transmission (34) qui bute contre une partie entraînée (2), qui est un rotor, et transmet la vibration de la partie de vibration (31) à la partie entraînée (2), le procédé comprenant les étapes consistant à :
configurer la partie de vibration (31) pour inclure une première partie de vibration (41) et une seconde partie de vibration (51) disposées côte à côte dans une deuxième direction (Y) coupant une première direction (X) qui est une direction dans laquelle la partie de vibration est alignée avec la partie entraînée (2) ;
configurer le module de vibration piézoélectrique (3) pour inclure un premier module de vibration piézoélectrique (4) et un second module de vibration piézoélectrique (5) empilés dans la deuxième direction (Y), le premier module de vibration piézoélectrique (4) étant disposé en une paire de manière à prendre en sandwich le second module de vibration piézoélectrique (5) entre elle, dans lequel le premier module de vibration piézoélectrique (4) inclut la première partie de vibration (41) et le second module de vibration (5) inclut la seconde partie de vibration (51), et
amener la partie de transmission (34) à vibrer en rotation en amenant la seconde partie de vibration (51) à effectuer une vibration longitudinale pour vibrer dans la première direction (X) tout en amenant la première partie de vibration (41) à effectuer une vibration latérale pour vibrer dans une troisième direction (Z) coupant la première direction (X) et la deuxième direction (Y),
dans lequel l'unité de commande (8) amène la première partie de vibration (41) à effectuer une vibration composite de vibration dans la troisième direction (Z) et de vibration dans la première direction (X), et
la partie de transmission (34) effectue une vibration en rotation en combinant une vibration latérale de la première partie de vibration (41) et une vibration longitudinale de la seconde partie de vibration (51), de sorte que la partie entraînée (2) est sensiblement déplacée uniquement par la vibration de la première partie de vibration (41), et la partie entraînée (2) est maintenue à la fois par la première partie de vibration (41) et la seconde partie de vibration (51).

8. Robot (1000) comprenant :
le dispositif d'entraînement piézoélectrique (1) selon l'une quelconque des revendications 1 à 6.

9. Appareil de transport de composant électronique (2000) comprenant :
le dispositif d'entraînement piézoélectrique (1) selon la revendication 1.

10. Imprimante (3000) comprenant :
le dispositif d'entraînement piézoélectrique (1) selon l'une quelconque des revendications 1 à 6.

11. Projecteur (4000) comprenant :
le dispositif d'entraînement piézoélectrique (1) selon l'une quelconque des revendications 1 à 6.
